# EUROPEAN PATENT APPLICATION

(11) **EP 4 398 696 A1**
(43) Date of publication of application: **10.07.2024**
(21) Application number: 22852994.7
(22) Date of filing: 01.08.2022
(51) Int. Cl.: H10K 50/00, C09K 11/06

(54) **ORGANIC ELECTROLUMINESCENT ELEMENT**

(30) Priority: 03.08.2021 JP 2021127351
(71) Applicant: Hodogaya Chemical Co., Ltd., Tokyo, 105-0021 (JP); SFC Co., Ltd., Cheongju-si, Chungcheongbuk-do 28122 (KR)
(72) Inventor: IZUMIDA, Junichi, Tokyo 105-0021 (JP); KO, Sang-Won, Tokyo 105-0021 (JP); LEE, Bong-Hyang, Tokyo 105-0021 (JP); RYU, Jung-Ho, Tokyo 105-0021 (JP); LEE, Jin-ho, Tokyo 105-0021 (JP); KASE, Kouki, Tokyo 105-0021 (JP); HAYASHI, Shuichi, Tokyo 105-0021 (JP); LEE, Se-Jin, Cheongju-si, Chungcheongbuk-do 28122 (KR); YU, Tae-Jung, Cheongju-si, Chungcheongbuk-do 28122 (KR); CHOI, Young-Tae, Cheongju-si, Chungcheongbuk-do 28122 (KR); JOO, Sung-Hoon, Cheongju-si, Chungcheongbuk-do 28122 (KR); YANG, Byung-Sun, Cheongju-si, Chungcheongbuk-do 28122 (KR); KIM, Ji-Hwan, Cheongju-si, Chungcheongbuk-do 28122 (KR); SHIN, Bong-Ki, Cheongju-si, Chungcheongbuk-do 28122 (KR)
(74) Representative: Forstmeyer, Dietmar
(86) International application number: PCT/JP2022/029469
(87) International publication number: WO 2023/013575

(57) **Abstract**

An object of the present invention is to provide a material for organic EL elements, the material being excellent in hole injecting/transporting performance, electron-blocking capability, stability in the form of a thin film, and durability. Another object of the present invention is to provide an organic EL element having high efficiency, a low driving voltage, and a long lifespan, by combining the aforementioned material with various materials for organic EL elements, the materials being excellent in hole/electron injecting/transporting performance, electron-blocking capability, stability in the form of a thin film, and durability, such that the properties of the individual materials can be effectively exhibited. Focusing on the finding that a triarylamine compound having a specific structure is excellent in hole injecting/transporting capability, stability in the form of a thin film, and durability, a specific arylamine compound was selected and used as a material for a hole-transporting layer to produce an organic EL element, and thus, the present invention has been accomplished.

## Description

### Technical Field

The present invention relates to an organic electroluminescent element (hereinafter referred to simply as "organic EL element"), which is a self-light emitting element favorably used in various display devices, and more particularly relates to an organic EL element including a specific arylamine compound.

### Background Art

Since organic EL elements are self-emissive elements, they have larger brightness and better viewability than elements including liquid crystals, and can provide a clearer display. For these reasons, active studies have been carried out on organic EL elements.

In 1987, C. W. Tang et al. of Eastman Kodak Company developed an element having a layered structure in which various functions were assigned to different materials, and thus made a practical organic EL element including organic materials. They made an organic EL element having a layered structure including a layer of a fluorescent substance capable of transporting electrons and a layer of an organic substance capable of transporting holes, and injected both charges into the layer of the fluorescent substance to thereby cause the layer to emit light, and the organic EL element thus achieved a luminance as high as 1,000 cd/m² or more at a voltage of 10 V or less (see Patent Literatures 1 and 2, for example).

Organic EL elements have been heretofore much improved to put them to practical use. Electroluminescent elements have been suggested in which an anode, a hole-injecting layer, a hole-transporting layer, a light-emitting layer, an electron-transporting layer, an electron-injecting layer, and a cathode are sequentially provided on a substrate to subdivide various functions in the multi-layered structure even further, and such electroluminescent elements successfully have high efficiency and durability (see Non-Patent Literature 1, for example).

For the purpose of further increasing luminous efficiency, attempts have been made to utilize triplet excitons, and the utilization of phosphorescent compounds has been investigated (see Non-Patent Literature 2, for example). Moreover, elements that utilize light emission by thermally activated delayed fluorescence (TADF) have also been developed. In 2011, Adachi et al. from Kyushu University achieved a result of an external quantum efficiency of 5.3% by an element including a thermally activated delayed fluorescence material (see Non-Patent Literature 3, for example).

The light-emitting layer can also be prepared by doping a charge-transporting compound, generally called a host material, with a fluorescent compound, a phosphorescent light emitting compound, or a material that radiates delayed fluorescence. As stated in the non-patent literature above, the selection of the organic materials in an organic EL element greatly affects the characteristics of that element, such as efficiency and durability (see Non-Patent Literature 2, for example).

In an organic EL element, the charges injected from both electrodes recombine in the light-emitting layer, thereby producing light emission, and how efficiently the both charges, i.e., the holes and the electrons, are transported to the light-emitting layer is of importance. Thus, the element needs to have excellent carrier balance. Additionally, higher luminous efficiency can be achieved by improving hole injectability and improving electron blockability, that is, the ability to block electrons injected from the cathode to thereby increase the probability of recombinations of holes and electrons in the light-emitting layer, and furthermore, by confining excitons generated in the light-emitting layer. Accordingly, the functions of the hole-transporting material are important, and there is a demand for a hole-transporting material having high hole injectability, high hole mobility, high electron blockability, and high durability against electrons.

Moreover, heat resistance and amorphousness of the materials are also important for lifespan of the element. A material with low heat resistance thermally decomposes, due to heat generated during the operation of the element, even at a low temperature, and thus the material deteriorates. A film made of a material with low amorphousness causes crystallization thereof even in a short period of time to result in deterioration of the element. Thus, the materials to be used are required to have high heat resistance and good amorphousness.

N,N'-diphenyl-N,N'-di(α-naphthyl)benzidine (NPD) and various aromatic amine derivatives are known as hole-transporting materials that have been heretofore used for organic EL elements (see Patent Literatures 1 and 2, for example). NPD has good hole-transporting capability, but has a glass transition point (Tg), which is a measure of heat resistance, as low as 96°C. Such a glass transition point cause a deterioration of the characteristics of elements due to crystallization of NPD under high-temperature conditions (see Non-Patent Literature 4, for example). Moreover, although the aromatic amine derivatives disclosed in Patent Literatures 1 and 2 include compounds having an excellent hole mobility of 10⁻³ cm²/Vs or higher, the electron-blocking capability thereof is insufficient. Thus, when using such a compound, some electrons pass through the light-emitting layer, and unfortunately, no increase in luminous efficiency can be expected. Accordingly, in order to further increase the efficiency, materials that have higher electron-blocking capability, higher stability in the form of a thin film, and higher heat resistance are needed. Although aromatic amine derivatives with high durability have been reported (see Patent Literature 3, for example), these aromatic amine derivatives are used as charge-transporting materials for a photoconductor for electrophotography, and there are no previous instances of application to an organic EL element.

Arylamine compounds having a substituted carbazole structure have been suggested as compounds improved in the properties including heat resistance and hole injectability (see Patent Literatures 4 and 5, for example). In elements in which these compounds are used for the hole-injecting layer or a hole-transporting layer, heat resistance, luminance efficiency, etc. thereof are improved, but are still insufficient. There is a demand for a further decrease in driving voltage and a further increase in luminance efficiency.

For improving the properties of organic EL elements and improve the production yield of elements, it is required to combine materials that are excellent in hole/electron injecting/transporting performance, stability in the form of a thin film, and durability to thereby obtain an element that is capable of causing holes and electrons to recombine highly efficiently and thus has high luminance efficiency, a low driving voltage, and a long lifespan.

Also, for improving the properties of organic EL elements, it is required to combine materials that are excellent in hole/electron injecting/transporting performance, stability in the form of a thin film, and durability to thereby obtain an element that has a good carrier balance, high efficiency, a low driving voltage, and a long lifespan.

### Citation List

### Patent Literature

Patent Literature 1: US 5792557
Patent Literature 2: US 5639914
Patent Literature 3: US 7799492B2
Patent Literature 4: US 8021764B2
Patent Literature 5: US 8394510B2
Patent Literature 6: US 10818844B2
Patent Literature 7: WO 2014/009310
Patent Literature 8: US 2019/0140177A1

### Non-Patent Literature

Non-Patent Literature 1: Proceedings of the 9th Meeting of the Japan Society of Applied Physics, pp. 55-61 (2001)
Non-Patent Literature 2: Proceedings of the 9th Meeting of the Japan Society of Applied Physics, pp. 23-31 (2001)
Non-Patent Literature 3: Appl. Phys. Let., 98, 083302 (2011)
Non-Patent Literature 4: Proceedings of the 3rd Meeting of the Japan OLED Forum, pp. 13-14 (2006)

### Summary of Invention

It is an object of the present invention to provide a material for an organic EL element having high efficiency and high durability, the material being excellent in hole injecting/transporting performance, electron-blocking capability, stability in the form of a thin film, and durability. It is another object of the present invention to provide an organic EL element having high efficiency, a low driving voltage, and a long lifespan, by combining the aforementioned material with various materials for organic EL elements, the materials being excellent in hole/electron injecting/transporting performance, electron-blocking capability, stability in the form of a thin film, and durability, such that the properties of the individual materials can be effectively exhibited.

A material for use in an organic EL element to be provided by the present invention should have the following physical properties: (1) good hole-injecting properties, (2) large hole mobility, (3) good stability in the form of a thin film, and (4) excellent heat resistance. Moreover, an organic EL element to be provided by the present invention should have the following physical properties: (1) high luminance efficiency and high-power efficiency, (2) a low voltage for the start of light emission, (3) a low actual driving voltage, and (4) a long lifespan.

To achieve the above-described objects, the inventors of the present invention have conducted in-depth research, and have found that arylamine compounds having a specific structure have excellent hole-injecting/transporting capability, stability in the form of a thin film, and durability, and that efficient transport of holes injected from the anode side can be caused when the arylamine compound is selected as the material for the hole-transporting layer. Furthermore, the inventors of the present invention have produced various organic EL elements including combinations of a light emitting material having a specific structure and the others and evaluated the properties of the organic EL elements. As a result, the present invention has been accomplished.

Specifically, the present invention provides the following organic EL element.
1) An organic EL element having a multilayer structure, wherein between an anode and a cathode, at least a first hole-transporting layer, a second hole-transporting layer, a blue light-emitting layer, and an electron-transporting layer are provided in this order from the anode side, and wherein a layer containing a triarylamine compound represented by the general formula (1) below is set between the first hole-transporting layer and the electron-transporting layer.

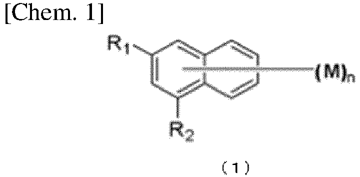

In the general formula (1), R₁ and R₂ may be the same or different and each represent a group of the general formula (2-1) or (2-2) below, and one of R₁ and R₂ represents a group of the general formula (2-1).

M represents a deuterium atom, a fluorine atom, a chlorine atom, a cyano group, a nitro group, a thiol group, a hydroxy group, a substituted or unsubstituted linear or branched alkyl group having 1 to 6 carbon atoms, a substituted or unsubstituted cycloalkyl group having 5 to 10 carbon atoms, a substituted or unsubstituted linear or branched alkenyl group having 2 to 6 carbon atoms, a substituted or unsubstituted linear or branched alkyloxy group having 1 to 6 carbon atoms, a cycloalkyloxy group having 5 to 10 carbon atoms and optionally having a substituent, a substituted or unsubstituted aryloxy group, a substituted or unsubstituted aromatic hydrocarbon group, a substituted or unsubstituted aromatic heterocyclic group, a substituted or unsubstituted silyl group, or a substituted or unsubstituted boron group.

n is an integer of 0 to 4. If n is 2 or more, M may be the same or different, and adjacent M may be optionally linked to each other to form a ring via a single bond, a substituted or unsubstituted methylene group, an oxygen atom, a sulfur atom, or a monosubstituted nitrogen atom.

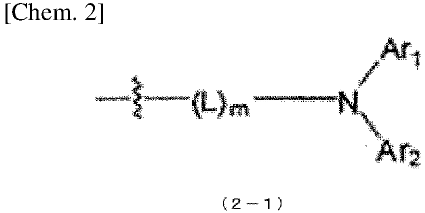

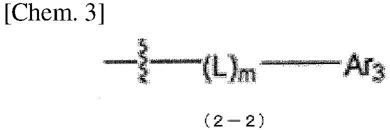

In the general formulae (2-1) and (2-2), L is a linking group and represents a substituted or unsubstituted divalent aromatic hydrocarbon group or a substituted or unsubstituted divalent aromatic heterocyclic group.

m is an integer of 0 to 4; if m is 0, L represents a single bond, and if m is 2 or more, L may be the same or different.

Ar₁ and Ar₂ may be the same or different and each represent a substituted or unsubstituted aromatic hydrocarbon group or a substituted or unsubstituted aromatic heterocyclic group, and
Ar₃ represents a substituted or unsubstituted aromatic hydrocarbon group.

2) The organic EL element as set forth in clause 1), wherein the layer containing the triarylamine compound represented by the general formula (1) is the second hole-transporting layer.

3) The organic EL element as set forth in clause 1) or 2), wherein, in the general formula (1), R₁ represents a group of the general formula (2-1), and R₂ represents a group of the general formula (2-2).

4) The organic EL element as set forth in clause 1) or 2), wherein, in the general formula (1), R₁ represents a group of the general formula (2-2), and R₂ represents a group of the general formula (2-1).

5) The organic EL element as set forth in any one of clauses 1) to 4), wherein the blue light-emitting layer contains a pyrene derivative having a pyrene skeleton in the molecule thereof.

5) The organic EL element as set forth in any one of clauses 1) to 4), wherein the blue light-emitting layer contains a compound represented by the general formula (3-1) or (3-2) below.

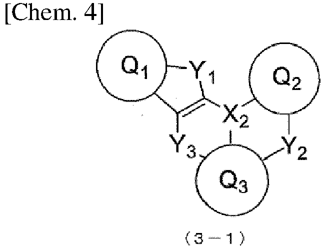

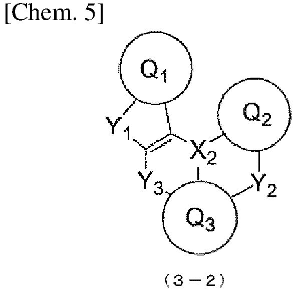

In the general formulae (3-1) and (3-2), Q₁, Q₂, and Q₃ may be the same or different and each represents a substituted or unsubstituted aromatic hydrocarbon or a substituted or unsubstituted aromatic heterocycle.

X₂ represents B, P, P=O, or P=S.

Y₁, Y₂, and Y₃ may be the same or different and each represent N-R₃, C-R₄R₅, O, S, Se, or Si-R₆R₇, where R₃, R₄, R₅, R₆, and R₇ may be the same or different and each represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, or a substituted or unsubstituted aryloxy group. The groups R₄ and R₅, and the groups R₆ and R₇, may be optionally bonded to each other to form a ring via a single bond, a substituted or unsubstituted methylene group, an oxygen atom, a sulfur atom, or a monosubstituted amino group, and if Y₁, Y₂, and Y₃ each represent N-R₃, C-R₄R₅, or Si-R₆R₇, each of R₃, R₄, R₅, R₆, and R₇ may be optionally bonded to its adjacent Q₁, Q₂, or Q₃ to form a ring via a single bond, a substituted or unsubstituted methylene group, an oxygen atom, a sulfur atom, or a monosubstituted amino group.

7) The organic EL element as set forth in any one of clauses 1) to 4), wherein the blue light-emitting layer contains an anthracene derivative having an anthracene skeleton in the molecule thereof.

In the general formulae (3-1) and (3-2) above, X represents B, P, P=O, or P=S. B is defined as a boron atom, P is defined as a phosphorus atom, P=O is defined as a phosphorus atom to which an oxygen atom is double-bonded, and P=S is defined as a phosphorus atom to which a sulfur atom is double-bonded.

In the general formulae (3-1) and (3-2) above, Y₁ to Y₃ may be the same or different and each represent N-R₃, C-R₄R₅, O, S, Se, or Si-R₆R₇. N-R₃ is defined as a nitrogen atom having R₃ as a substituent, C-R₄R₅ is defined as a carbon atom having R₄ and R₅ as substituents, O is defined as an oxygen atom, S is defined as a sulfur atom, Se is defined as a selenium atom, and Si-R₆R₇ is defined as a silicon atom having R₆ and R₇ as substituents.

Specific examples of the "aromatic hydrocarbon group" or the "aromatic heterocyclic group" in the "substituted or unsubstituted aromatic hydrocarbon group" or the "substituted or unsubstituted aromatic heterocyclic group" represented by M, Ar₁ to Ar₃, Q₁ to Q₃, and R₃ to R₇ in the general formulae (1), (3-1), and (3-2) above include a phenyl group, a biphenylyl group, a terphenylyl group, a stilbene group, a naphthyl group, an anthracenyl group, a phenanthrenyl group, a pyrenyl group, a perylenyl group, a tetracenyl group, a chrysenyl group, a fluorenyl group, a spirofluorenyl group, a furanyl group, a pyronyl group, a thionyl group, an imidazolyl group, a thiazolyl group, an oxazolyl group, an oxadiazolyl group, a triazolyl group, a pyridyl group, a pyrimidinyl group, a triazinyl group, an acridinyl group, a pyridazinyl group, a pyrazinyl group, a quinolinyl group, an isoquinolinyl group, a quinazolinyl group, a quinoxalinyl group, a phthalazinyl group, a pyridopyrimidinyl group, a pyridopyrazinyl group, a pyrazinopyrazinyl group, an indolyl group, a carbazolyl group, a benzoxazolyl group, a benzimidazolyl group, a benzothiazolyl group, a benzocarbazolyl group, a benzothionyl group, a benzofuranyl group, a dibenzothionyl group, a dibenzofuranyl group, a phenanthronyl group, a thiazolyl group, an isoxazolyl group, an oxadiazolyl group, a thiadiazolyl group, a phenoxazinyl group, a phenothiazinyl group, and a carbolinyl group, and also a group selected from aryl groups having 6 to 30 carbon atoms and heteroaryl groups having 2 to 20 carbon atoms.

Specific examples of the "aromatic hydrocarbon" or the "aromatic heterocycle" in the "substituted or unsubstituted aromatic hydrocarbon" or the "substituted or unsubstituted aromatic heterocycle" in the "divalent group of a substituted or unsubstituted aromatic hydrocarbon or a substituted or unsubstituted aromatic heterocycle" represented by L in the general formulae (2-1) and (2-2) above include benzene, biphenyl, terphenyl, tetrakisphenyl, styrene, naphthalene, anthracene, acenaphthalene, fluorene, phenanthrene, indan, pyrene, triphenylene, pyridine, pyrimidine, triazine, pyrrole, furan, thiophene, quinoline, isoquinoline, benzofuran, benzothiophene, indoline, carbazole, carboline, benzoxazole, benzothiazole, quinoxaline, benzimidazole, pyrazole, dibenzofuran, dibenzothiophene, naphthyridine, phenanthroline, and acridine.

The "divalent group of a substituted or unsubstituted aromatic hydrocarbon or a substituted or unsubstituted aromatic heterocycle" represented by L in the general formulae (2-1) and (2-2) above means a divalent group obtained by removing two hydrogen atoms from the above-described "aromatic hydrocarbon" or "aromatic heterocycle".

Specific examples of the "linear or branched alkyl group having 1 to 6 carbon atoms", the cycloalkyl group having 5 to 10 carbon atoms", the "linear or branched alkenyl group having 2 to 6 carbon atoms", the "linear or branched alkyloxy group having 1 to 6 carbon atoms", the "cycloalkyloxy group having 5 to 10 carbon atoms", or the "aryloxy group" in the "linear or branched alkyl group having 1 to 6 carbon atoms and optionally having a substituent", the "cycloalkyl group having 5 to 10 carbon atoms and optionally having a substituent", the "linear or branched alkenyl group having 2 to 6 carbon atoms and optionally having a substituent", the "linear or branched alkyloxy group having 1 to 6 carbon atoms and optionally having a substituent", the "cycloalkyloxy group having 5 to 10 carbon atoms and optionally having a substituent", or the "substituted or unsubstituted aryloxy group" represented by M and R₃ to R₇ in the general formulae (1), (3-1), and (3-2) above include a methyl group, an ethyl group, an n-propyl group, an isopropyl group, an n-butyl group, an isobutyl group, a tert-butyl group, an n-pentyl group, an isopentyl group, a neopentyl group, an n-hexyl group, a cyclopentyl group, a cyclohexyl group, a 1-adamanthyl group, a 2-adamanthyl group, a vinyl group, an allyl group, an isopropenyl group, a 2-butenyl group, a methyloxy group, an ethyloxy group, an n-propyloxy group, a cyclopentyloxy group, a cyclohexyloxy group, a 1-adamantyloxy group, a phenyloxy group, a tolyloxy group, and a biphenyloxy group.

Specific examples of the "substituent" in the "substituted aromatic hydrocarbon group", the "substituted aromatic heterocyclic group", the "linear or branched alkyl group having 1 to 6 carbon atoms and optionally having a substituent", the "cycloalkyl group having 5 to 10 carbon atoms and optionally having a substituent", the "linear or branched alkenyl group having 2 to 6 carbon atoms and optionally having a substituent", the "linear or branched alkyloxy group having 1 to 6 carbon atoms and optionally having a substituent", the "cycloalkyloxy group having 5 to 10 carbon atoms and optionally having a substituent", the "substituted aryloxy group", the "substituted silyl group", or the "substituted boron group" represented by M, L, Ar₁ to Ar₃, Q₁ to Q₃, and R₃ to R₇ in the general formulae (1), (2-1), (2-2), (3-1), and (3-2) above include a deuterium atom, a cyano group, or a nitro group; a halogen atom such as a fluorine atom, a chlorine atom, a bromine atom, or an iodine atom; a silyl group such as a trimethylsilyl group or a triphenylsilyl group; a linear or branched alkyl group having 1 to 6 carbon atoms such as a methyl group, an ethyl group, or a propyl group; a linear or branched alkyloxy group having 1 to 6 carbon atoms such as a methyloxy group, an ethyloxy group, or a propyloxy group; an alkenyl group such as a vinyl group or an allyl group; an aryloxy group such as a phenyloxy group or a tolyloxy group; an arylalkyloxy group such as a benzyloxy group or a phenethyloxy group; an aromatic hydrocarbon group or a fused polycyclic aromatic group such as a phenyl group, a biphenylyl group, a terphenylyl group, a naphthyl group, an anthracenyl group, a phenanthrenyl group, a fluorenyl group, a spirobifluorenyl group, an indenyl group, a pyrenyl group, a perylenyl group, a fluoranthenyl group, or a triphenylenyl group; or a pyridyl group, a thienyl group, a furyl group, a pyrrolyl group, a quinolyl group, an isoquinolyl group, a benzofuranyl group, a benzothienyl group, an indolyl group, a carbazolyl group, an imidazopyridyl group, a benzoxazolyl group, a benzothiazolyl group, a quinoxalinyl group, a benzimidazolyl group, a pyrazolyl group, a dibenzofuranyl group, a dibenzothienyl group, and a carbolinyl group, and also an aryl group having 6 to 30 carbon atoms, and a heteroaryl group having 2 to 20 carbon atoms. These substituents may be further substituted with any of the above-listed substituents. Furthermore, such a substituent and a benzene ring substituted with the substituent, or a plurality of substituents on the same benzene ring, may be bonded to each other via a single bond, a substituted or unsubstituted methylene group, an oxygen atom, or a sulfur atom to form a ring.

In the general formula (1) above, M preferably represents "heavy hydrogen" or a "substituted or unsubstituted aromatic hydrocarbon group", more preferably an unsubstituted phenyl group, an unsubstituted naphthyl group, an unsubstituted biphenylyl group, a phenyl group substituted with a naphthyl group, an unsubstituted terphenylyl group, or a phenyl group substituted with a terphenylyl group, and particularly preferably an unsubstituted phenyl group, an unsubstituted naphthyl group, an unsubstituted biphenylyl group, or a phenyl group substituted with a naphthyl group.

In the general formulae (2-1) and (2-2) above, L preferably represents a "substituted or unsubstituted divalent aromatic hydrocarbon group", more preferably a divalent group obtained by removing two hydrogen atoms from benzene, biphenyl, terphenyl, or naphthalene, and particularly preferably a divalent group obtained by removing two hydrogen atoms from benzene or biphenyl.

In the general formula (2-1) above, Ar₁ and Ar₂ each preferably represent a "substituted or unsubstituted aromatic hydrocarbon group", more preferably a substituted or unsubstituted phenyl group, a substituted or unsubstituted naphthyl group, a substituted or unsubstituted biphenylyl group, a substituted or unsubstituted terphenylyl group, a substituted or unsubstituted phenanthrenyl group, or a substituted or unsubstituted fluorenyl group, and particularly preferably a substituted or unsubstituted phenyl group, an unsubstituted naphthyl group, a substituted or unsubstituted biphenylyl group, or an unsubstituted phenanthrenyl group. The substituent on the phenyl group or the biphenylyl group is preferably a naphthyl group, a substituted or unsubstituted dibenzofuranyl group, or a carbazolyl group.

In the general formula (2-2) above, Ar₃ preferably represents a "substituted or unsubstituted aromatic hydrocarbon group", more preferably a substituted or unsubstituted phenyl group, a substituted or unsubstituted naphthyl group, a substituted or unsubstituted biphenylyl group, or a substituted or unsubstituted terphenylyl group, and particularly preferably an unsubstituted phenyl group, an unsubstituted naphthyl group, an unsubstituted biphenylyl group, an unsubstituted terphenylyl group, or an unsubstituted dibenzofuranyl group.

In the general formulae (3-1) and (3-2) above, the "aromatic hydrocarbon" or the "aromatic heterocycle" in the "substituted or unsubstituted aromatic hydrocarbon" or the "substituted or unsubstituted aromatic heterocycle" represented by Q₁ to Q₃ is preferably benzene, naphthalene, phenanthrene, pyridine, pyrimidine, indene, benzofuran, benzothiophene, or indole, and more preferably benzene or naphthalene.

In the general formulae (3-1) and (3-2) above, X₂ preferably represents B. Y₁ preferably represents N-R₃, O, or S, and more preferably O S. In the general formula (3-1) above, it is preferable that at least one of Y₂ and Y₃ should represent N-R₃, and it is much preferable that both Y₂ and Y₃ should represent N-R₃. R₃ preferably represents a "substituted or unsubstituted aromatic hydrocarbon group", and more preferably a substituted or unsubstituted phenyl, biphenylyl, terphenylyl, or naphthyl group.

Examples of the compounds represented by the general formulae (3-1) and (3-2) above include compounds having skeleton structures represented by the general formulae (4) to (7) below.

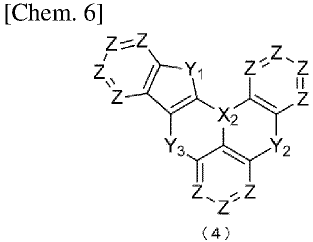

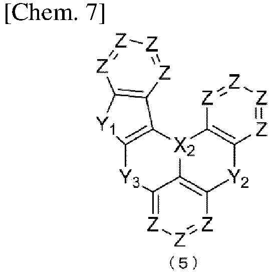

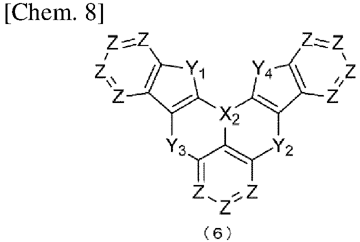

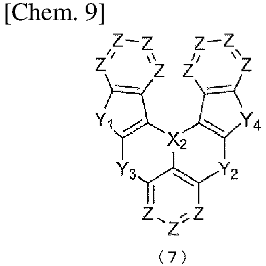

In the general formulae (4) to (7), X₂ and Y₁ to Y₃ are as defined in the general formulae (3-1) and (3-2) above, Y₄ represents N-R₃, C-R₄R₅, O, S, Se, or Si-R₆R₇, and R₃ to R₇ are as defined in the general formulae (3-1) and (3-2) above.

Z may be the same or different and each represents CR₈ or N, where R₈ may be the same or different and each represents a hydrogen atom, a deuterium atom, a halogen group, a cyano group, a nitro group, a linear or branched alkyl group having 1 to 6 carbon atoms and optionally having a substituent, a cycloalkyl group having 5 to 10 carbon atoms and optionally having a substituent, a linear or branched alkyloxy group having 1 to 6 carbon atoms and optionally having a substituent, a linear or branched alkylthioxy group having 1 to 6 carbon atoms and optionally having a substituent, a linear or branched alkylamine group having 1 to 6 carbon atoms and optionally having a substituent, a linear or branched alkylsilyl group having 3 to 10 carbon atoms and optionally having a substituent, a substituted or unsubstituted aromatic hydrocarbon group, a substituted or unsubstituted aromatic heterocyclic group, a substituted or unsubstituted aryloxy group, a substituted or unsubstituted arylthioxy group, a substituted or unsubstituted arylamine group, or a substituted or unsubstituted arylsilyl group. R₈ can be bonded to another R₈, or can be bonded to an adjacent substituent, to form an alicyclic or aromatic monocyclic or polycyclic ring. The carbon atoms in the alicyclic or aromatic monocyclic or polycyclic ring can be replaced with any one or more heteroatoms selected from N, S, and O.

Specific examples of the "linear or branched alkyl group having 1 to 6 carbon atoms" or the "cycloalkyl group having 5 to 10 carbon atoms" in the "linear or branched alkyl group having 1 to 6 carbon atoms and optionally having a substituent" or the "cycloalkyl group having 5 to 10 carbon atoms and optionally having a substituent" represented by R₈ in the general formulae (4) to (7) above include a methyl group, an ethyl group, an n-propyl group, an isopropyl group, an n-butyl group, an isobutyl group, a tert-butyl group, an n-pentyl group, an isopentyl group, a neopentyl group, an n-hexyl group, a cyclopentyl group, a cyclohexyl group, a 1-adamantyl group, and a 2-adamantyl group.

Specific examples of the "linear or branched alkyloxy group having 1 to 6 carbon atoms" in the "linear or branched alkyloxy group having 1 to 6 carbon atoms and optionally having a substituent" represented by R₈ in the general formulae (4) to (7) above include a methyloxy group, an ethyloxy group, an n-propyloxy group, an isopropyloxy group, an n-butyloxy group, a tert-butyloxy group, an n-pentyloxy group, and an n-hexyloxy group.

Specific examples of the "linear or branched alkylthioxy group having 1 to 6 carbon atoms" in the "linear or branched alkylthioxy group having 1 to 6 carbon atoms and optionally having a substituent" represented by R₈ in the general formulae (4) to (7) above include a methylthioxy group, an ethylthioxy group, an n-propylthioxy group, an isopropylthioxy group, an n-butylthioxy group, an isobutylthioxy group, a tert-butylthioxy group, an n-pentylthioxy group, an isopentylthioxy group, a neopentylthioxy group, and an n-hexylthioxy group.

Specific examples of the "linear or branched alkylamine group having 1 to 6 carbon atoms" in the "linear or branched alkylamino group having 1 to 6 carbon atoms and optionally having a substituent" represented by R₈ in the general formulae (4) to (7) above include a methylamine group, an ethylamine group, an n-propylamine group, an isopropylamine group, an n-butylamine group, a tert-butylamine group, an n-pentylamine group, an isopentylamine group, a neopentylamine group, and an n-hexylamine group.

Specific examples of the "linear or branched alkylsilyl group having 3 to 10 carbon atoms" in the "linear or branched alkylsilyl group having 3 to 10 carbon atoms and optionally having a substituent" represented by R₈ in the general formulae (4) to (7) above include a trimethylsilyl group, a triethylsilyl group, a tri-n-propylsilyl group, a triisopropylsilyl group, an n-butyldimethylsilyl group, an isobutyldimethylsilyl group, and a tert-butyldimethylsilyl group.

Specific examples of the "aromatic hydrocarbon group" or the "aromatic heterocyclic group" in the "substituted or unsubstituted aromatic hydrocarbon group" or the "substituted or unsubstituted aromatic heterocyclic group" represented by R₈ in the general formulae (4) to (7) above include a phenyl group, a biphenylyl group, a terphenylyl group, a naphthyl group, an anthracenyl group, a phenanthrenyl group, a pyridyl group, a pyrimidinyl group, a triazinyl group, a furyl group, a pyrrolyl group, and a thienyl group.

Specific examples of the "aryloxy group" in the "substituted or unsubstituted aryloxy group" represented by R₈ in the general formulae (4) to (7) above include a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, and a perylenyloxy group.

Specific examples of the "arylthioxy group" in the "substituted or unsubstituted arylthioxy group" represented by R₈ in the general formulae (4) to (7) above include a phenylthioxy group, a biphenylylthioxy group, a terphenylylthioxy group, a naphthylthioxy group, an anthracenylthioxy group, a phenanthrenylthioxy group, a fluorenylthioxy group, an indenylthioxy group, a pyrenylthioxy group, and a perylenylthioxy group.

Specific examples of the "arylamine group" in the "substituted or unsubstituted arylamine group" represented by R₈ in the general formulae (4) to (7) above include a phenylamine group, a biphenylylamine group, a terphenylylamine group, a naphthylamine group, an anthracenylamine group, a phenanthrenylamine group, a fluorenylamine group, an indenylamine group, a pyrenylamine group, and a perylenylamine group.

Specific examples of the "arylsilyl group" in the "substituted or unsubstituted arylsilyl group" represented by R₈ in the general formulae (4) to (7) above include a triphenylsilyl group, a trinaphthylsilyl group, and a terphenylylsilyl group.

The arylamine compound represented by the general formula (1) above for use in the organic EL element of the present invention has larger hole mobility, superior electron blocking capability, superior amorphousness, and higher stability in the form of a thin film, compared with conventional hole-transporting materials. It is thus possible to obtain an organic EL element having high efficiency, a low driving voltage, and a long lifespan, when the arylamine compound is used as a material for a hole-transporting layer.

Furthermore, in the present invention, the hole-transporting layer has a two-layer structure consisting of a first hole-transporting layer and a second hole-transporting layer, and when the second hole-transporting layer is located on the side adjacent to a light-emitting layer and is formed of the arylamine compound represented by the general formula (1) above, it is possible to make the most of the electron blocking performance of the arylamine compound, whereby an organic EL element having even higher efficiency and an even longer lifespan can be obtained.

### Brief Description of Drawings

[Fig. 1] Structural formulae of Compounds (1-1) to (1-9) as examples of the arylamine compound represented by the general formula (1).
[Fig. 2] Structural formulae of Compounds (1-10) to (1-18) as examples of the arylamine compound represented by the general formula (1).
[Fig. 3] Structural formulae of Compounds (1-19) to 1-27 as examples of the arylamine compound represented by the general formula (1).
[Fig. 4] Structural formulae of Compounds (1-28) to (1-36) as examples of the arylamine compound represented by the general formula (1).
[Fig. 5] Structural formulae of Compounds (1-37) to (1-48) as examples of the arylamine compound represented by the general formula (1).
[Fig. 6] Structural formulae of Compounds (1-49) to (1-57) as examples of the arylamine compound represented by the general formula (1).
[Fig. 7] Structural formulae of Compounds (1-58) to (1-69) as examples of the arylamine compound represented by the general formula (1).
[Fig. 8] Structural formulae of Compounds (1-70) to (1-81) as examples of the arylamine compound represented by the general formula (1).
[Fig. 9] Structural formulae of Compounds (1-82) to (1-90) as examples of the arylamine compound represented by the general formula (1).
[Fig. 10] Structural formulae of Compounds (1-91) to (1-99) as examples of the arylamine compound represented by the general formula (1).
[Fig. 11] Structural formulae of Compounds (1-100) to (1-108) as examples of the arylamine compound represented by the general formula (1).
[Fig. 12]Structural formulae of Compounds (2-1) to (2-15) as examples of the compound represented by the general formula (3-1).
[Fig. 13] Structural formulae of Compounds (2-16) to (2-24) as examples of the compound represented by the general formula (3-1).
[Fig. 14] Structural formulae of Compounds (3-1) to (3-6) as examples of the compound represented by the general formula (3-2).
[Fig. 15] The structure of the organic EL elements of examples of the present invention and comparative examples.

### Description of Embodiments

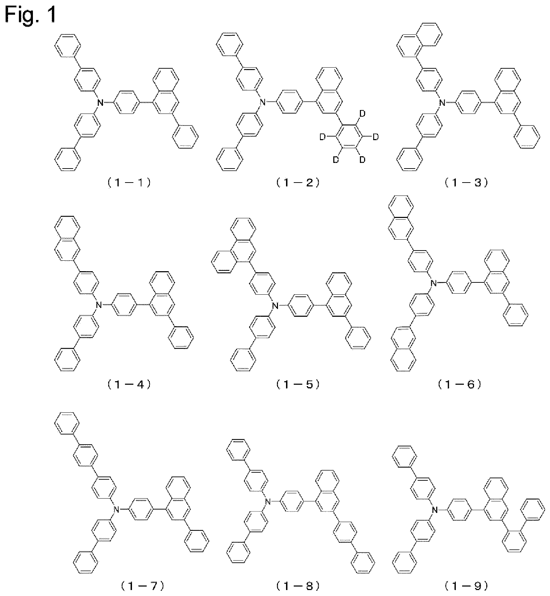

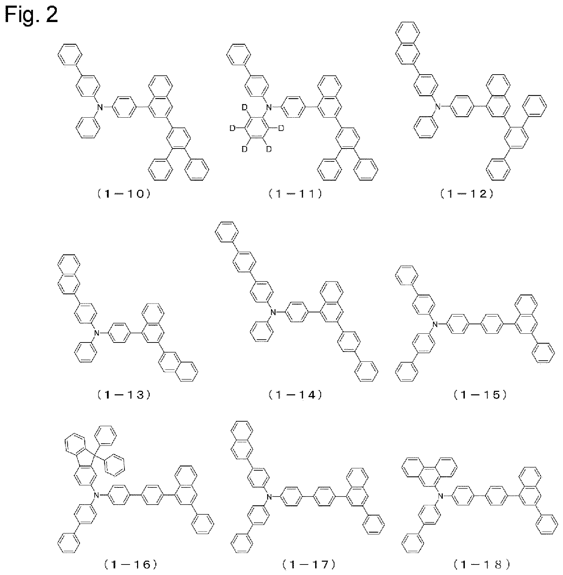

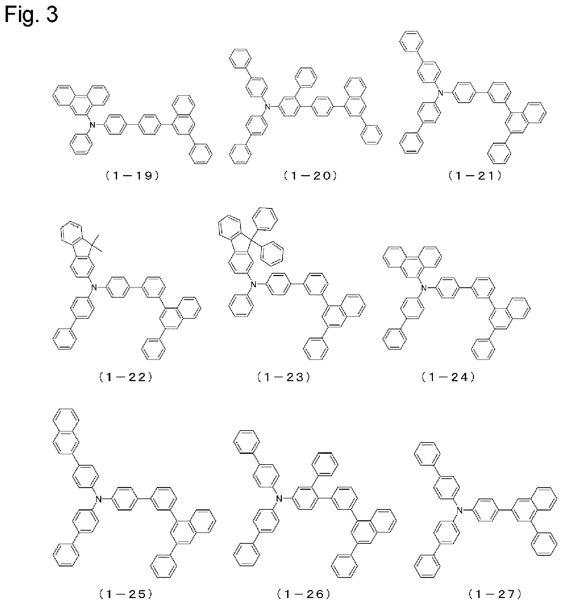

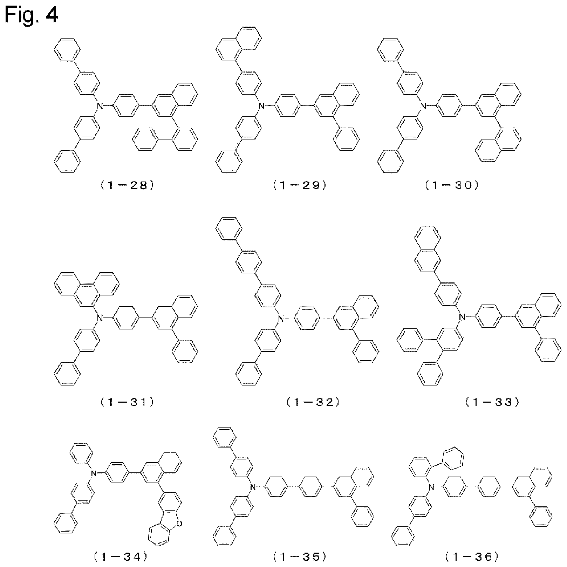

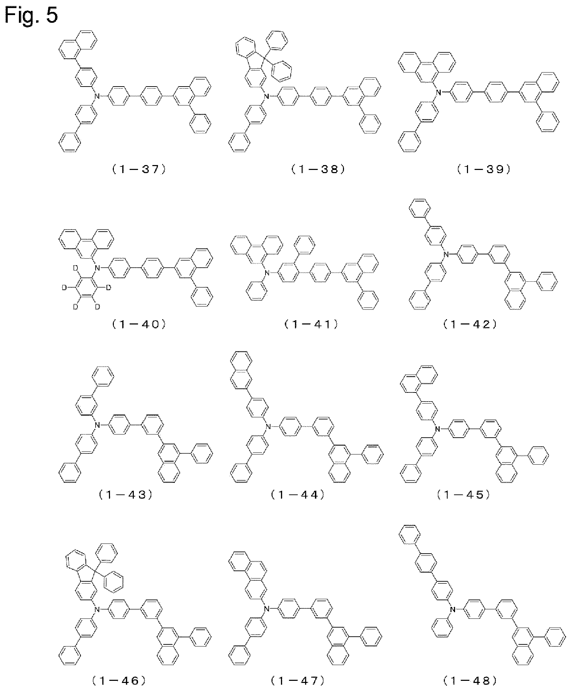

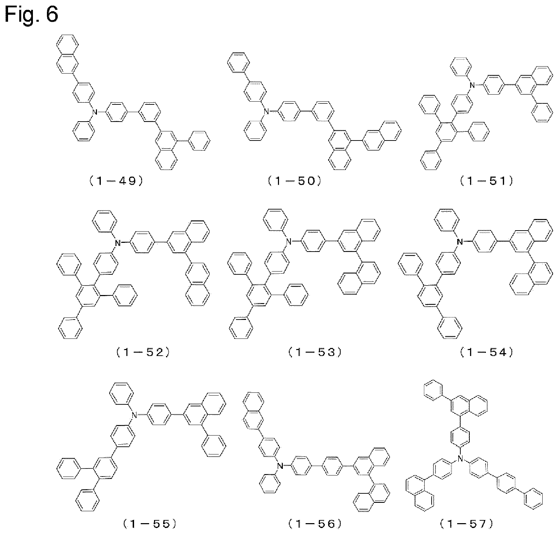

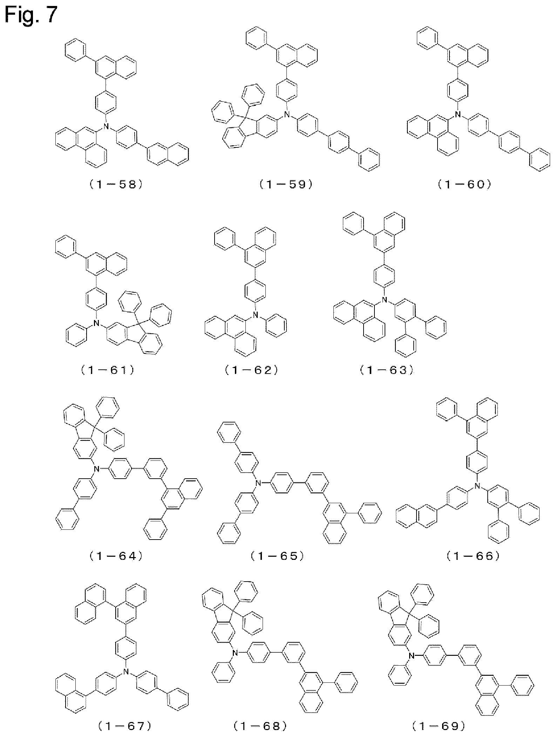

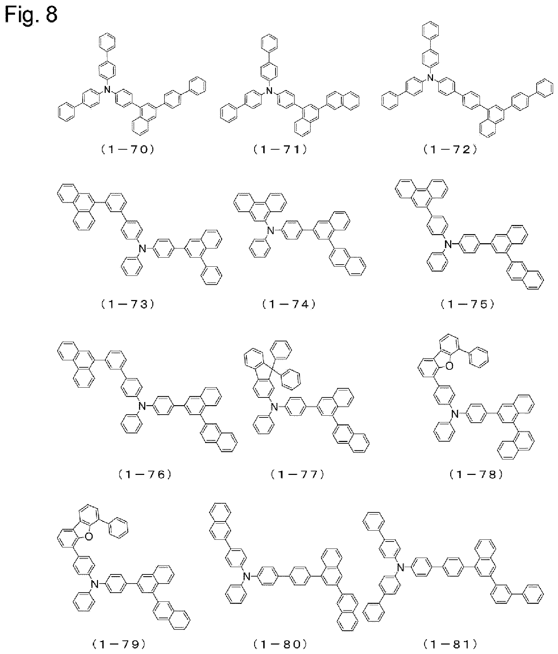

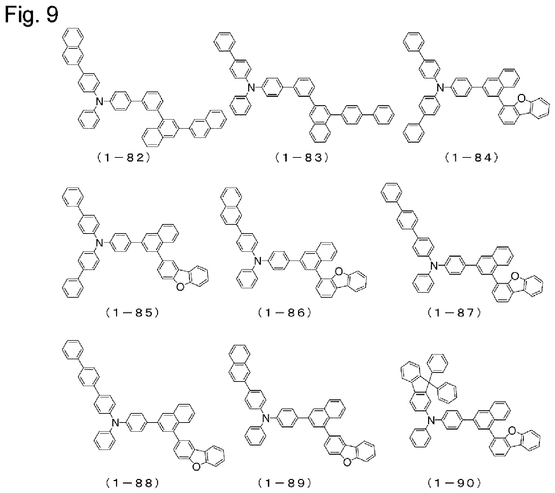

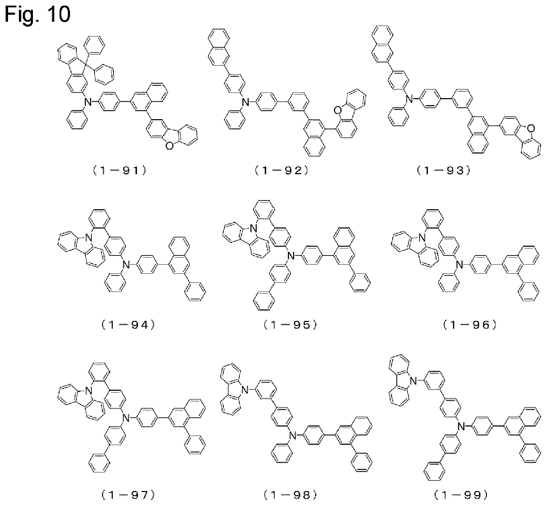

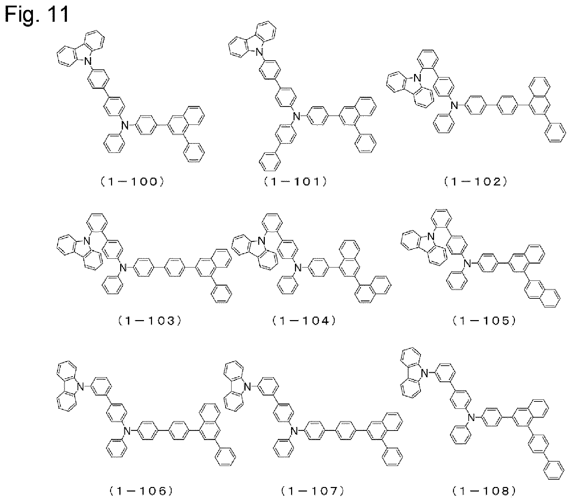

Figs. 1 to 11 show specific preferred examples of the arylamine compound represented by the general formula (1) above and suitably used for the organic EL element of the present invention. However, the present invention is not limited by these compounds.

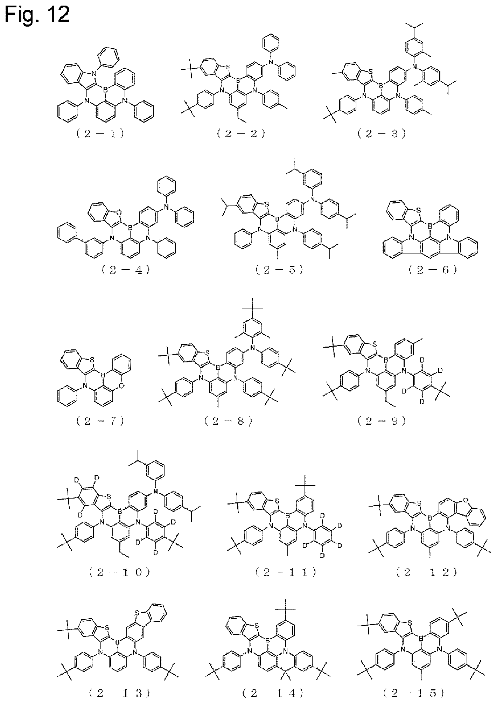

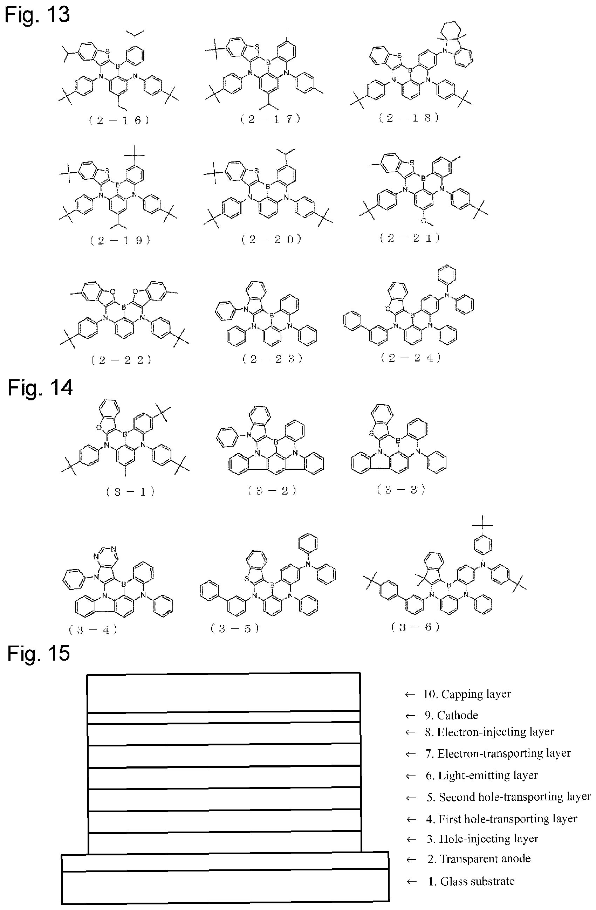

Figs. 12 and 13 show specific preferred examples of the compound represented by the general formula (3-1) above and suitably used for the organic EL element of the present invention. However, the present invention is not limited by these compounds.

Fig. 14 shows specific preferred examples of the compound represented by the general formula (3-2) above and suitably used for the organic EL element of the present invention. However, the present invention is not limited by these compounds.

The arylamine compound represented by the general formula (1) can be purified by any purification method such as column chromatography, adsorption using silica gel, activated carbon, activated clay, or the like, recrystallization or crystallization from a solvent, or sublimation. The compound can be identified by NMR analysis. Preferably, the melting point, the glass transition point (Tg), and the work function are measured as physical properties. The melting point is a measure of the vapor deposition properties, the glass transition point (Tg) is a measure of stability in the form of a thin film, and the work function is a measure of the hole transportability and hole blockability. Preferably, the compound used in the organic EL element of the present invention is purified by, for example, column chromatography, adsorption using silica gel, activated carbon, activated clay, or the like, recrystallization or crystallization from a solvent, or sublimation, and then finally purified by sublimation, before use.

The melting point and the glass transition point (Tg) can be measured, for example, on the compound in the form of power using a high-sensitivity differential scanning calorimeter (DSC3100SA manufactured by Bruker AXS K.K.).

The work function can be determined, for example, on the compound in the form of a thin film with a thickness of 100 nm formed on an ITO substrate using an ionization potential measuring device (PYS-202 manufactured by Sumitomo Heavy Industries, Ltd.).

The organic EL element of the present invention may have a structure in which an anode, a hole-transporting layer, a light-emitting layer, an electron-transporting layer, and a cathode are sequentially provided on a substrate; and the structure may further include a hole-injecting layer between the anode and the hole-transporting layer, a hole-blocking layer between the light-emitting layer and the electron-transporting layer, and an electron-injecting layer between the electron-transporting layer and the cathode. In these multilayer structures, a single layer serving as both the hole-injecting layer and the hole-transporting layer, or a single layer serving as both the electron-injecting layer and the electron-transporting layer, for example, may be provided. It is also possible to stack two or more organic layers having the same function. Specifically, two hole-transporting layers may be stacked, two light-emitting layers may be stacked, and two electron-transporting layers may be stacked. The organic EL element of the present invention preferably has the following configuration: the hole-transporting layer has a two-layer structure consisting of a first hole-transporting layer and a second hole-transporting layer, and the second hole-transporting layer is adjacent to the light-emitting layer and functions as an electron-blocking layer.

An electrode material having a high work function, such as ITO or gold, is used for the anode of the organic EL element of the present invention. Examples of the material for the hole-injecting layer of the organic EL element of the present invention include starburst triphenylamine derivatives and various triphenylamine tetramers; porphyrin compounds typified by copper phthalocyanine; acceptor type heterocyclic compounds such as hexacyanoazatriphenylene; coating type polymer materials. These materials may be used in any known method for forming a thin film, such as vapor deposition or even spin coating or inkjet printing.

Examples of hole-transporting materials that can be used for the hole-transporting layer of the organic EL element of the present invention include: benzidine derivatives, such as N,N'-diphenyl-N,N'-di(m-tolyl)-benzidine (TPD), N,N'-diphenyl-N,N'-di(α-naphthyl)benzidine (NPD), and N,N,N',N'-tetrabiphenylyl benzidine; 1,1-bis[4-(di-4-tolylamino)phenyl]cyclohexane (TAPC); and triphenylamine derivatives represented by the general formula (1) above, and also various triphenylamine derivatives. These materials may be used singly to form a film, or any of these may be mixed with another material and used to form a single layer film. Alternatively, the hole-transporting layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above. These materials may be used in any known method for forming a thin film, such as vapor deposition or even spin coating or inkjet printing.

It is also possible to use, in the hole-injecting layer or the hole-transporting layer, a material obtained by p-doping a material normally used for these layers with trisbromophenylamine hexachloroantimony or a radialene derivative (see Patent Literature 7, for example); and a polymer compound having the structure of a benzidine derivative, such as TPD, as a partial structure thereof.

The arylamine compound represented by the general formula (1) above is used for the second hole-transporting layer, which is adjacent to the light-emitting layer, in the organic EL element of the present invention. Examples of hole transporting materials that can be mixed with, or can be simultaneously used with, the arylamine compound represented by the general formula (1) above include compounds having an electron-blocking effect, such as carbazole derivatives such as 4,4' ,4" -tri(N-carbazolyl)triphenylamine (TCTA), 9,9-bis[4-(carbazol-9-yl)phenyl]fluorene, 1,3-bis(carbazol-9-yl)benzene (mCP), and 2,2-bis(4-carbazol-9-ylphenyl)adamantane (Ad-Cz) and compounds that have a triphenylsilyl group and a triarylamine structure and are typified by 9-[4-(carbazol-9-yl)phenyl]-9-[4-(triphenylsilyl)phenyl]-9H-fluorene.

These materials may be used singly to form a film, or any of them may be mixed with another material and used to form a single layer film. Alternatively, the second hole-transporting layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above. These materials may be used in any known method for forming a thin film, such as vapor deposition or even spin coating or inkjet printing.

Examples of the materials for the light-emitting layer of the organic EL element of the present invention include: metal complexes of quinolinol derivatives such as Alq₃, and various other types of metal complexes; an anthracene derivative, a bisstyrylbenzene derivative, a pyrene derivative, an oxazole derivative, and a poly(p-phenylene vinylene) derivative. The light-emitting layer may also include a host material and a dopant material. As the host material, an anthracene derivative is preferably used. Other examples of the host material include the above-listed light emitting materials, and also a heterocyclic compound having an indole ring as a partial structure of a fused ring, a heterocyclic compound having a carbazole ring as a partial structure of a fused ring, a carbazole derivative, a thiazole derivative, a benzimidazole derivative, and a polydialkylfluorene derivative. As the dopant material, a pyrene derivative and a compound represented by the general formula (3) or (4) above are preferably used. Other examples of the dopant material include quinacridone, coumarin, rubrene, perylene, and derivatives thereof; a benzopyran derivative, an indenophenanthrene derivative, a rhodamine derivative, and an aminostyryl derivative. These materials may be used singly to form a film, or any of them may be mixed with another material and used to form a single layer film. Alternatively, the light-emitting layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above.

A phosphorescent emitter can also be used as the light emitting material. The phosphorescent emitter may be a metal complex of iridium, platinum, or the like. A blue phosphorescent emitter such as FIrpic or FIr6 is used, and, in this case, carbazole derivatives such as 4,4'-di(N-carbazolyl)biphenyl (CBP), TCTA, and mCP, which are host materials having hole-injecting/transporting capability, can be used as the host material. A host material having electron-transporting capability may also be used, including p-bis(triphenylsilyl)benzene (UGH2) and 2,2',2"-(1,3,5-phenylene)-tris(1-phenyl-1H-benzimidazole) (TPBI). Use of these materials enables production of a high-performance organic EL element.

In order to avoid concentration quenching, doping of a host material with a phosphorescent emitter is preferably performed by co-deposition in an amount within a range of 1 to 30 wt% based on the entire light-emitting layer.

As the light emitting material, a material that emits delayed fluorescence can also be used, including a CDCB derivative such as PIC-TRZ, CC2TA, PXZ-TRZ, and 4CzIPN (see Non-Patent Literature 3, for example).

These materials may be used in any known method for forming a thin film, such as vapor deposition or even spin coating or inkjet printing.

Examples of the materials used for the hole-blocking layer of the organic EL element of the present invention include compounds having a hole-blocking effect, including a phenanthroline derivative, such as bathocuproine (BCP); a metal complex of a quinolinol derivative, such as aluminum(III)bis(2-methyl-8-quinolinato)-4-phenylphenolate (hereinafter abbreviated as BAlq); and also, various types of rare-earth complexes; a triazole derivative; a triazine derivative; and an oxadiazole derivative. These materials may also serve as the material of the electron-transporting layer. These materials may be used singly to form a film, or any of them may be mixed with another material and used to form a single layer film. Alternatively, the hole-blocking layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above. These materials may be used in any known method for forming a thin film, such as vapor deposition or even spin coating or inkjet printing.

Examples of the materials used for the electron-transporting layer of the organic EL element of the present invention include metal complexes of quinolinol derivatives, such as Alq₃ and BAlq; various types of metal complexes; a triazole derivative; a triazine derivative; an oxadiazole derivative; a pyridine derivative; a pyrimidine derivative; a benzimidazole derivative; a thiadiazole derivative; an anthracene derivative; a carbodiimide derivative; a quinoxaline derivative; a pyridoindole derivative; a phenanthroline derivative; and a silole derivative. These materials may be used singly to form a film, or any of them may be mixed with another material and used to form a single layer film. Alternatively, the electron-transporting layer may have a layered structure composed of different layers each formed of a single kind of the materials described above, a layered structure composed of different layers each formed of a mixture of the materials described above, or a layered structure composed of a layer formed of a single kind of the materials described above and a layer formed of a mixture of two or more of the materials described above. These materials may be used in any known method for forming a thin film, such as vapor deposition or even spin coating or inkjet printing.

Examples of the materials used for the electron-injecting layer of the organic EL element of the present invention include alkali metal salts such as lithium fluoride and cesium fluoride, alkaline earth metal salts such as magnesium fluoride, metal complexes of quinolinol derivatives, such as lithium quinolinol, metal oxides such as aluminum oxide, and metals such as ytterbium (Yb), samarium (Sm), calcium (Ca), strontium (Sr), and cesium (Cs). The electron-injecting layer can be omitted when the electron-transporting layer and the cathode are suitably selected.

Furthermore, a material obtained by n-doping a material normally used for an electron-injecting layer or an electron-transporting layer with a metal such as cesium can be used for the electron-injecting layer or the electron-transporting layer.

For the cathode of the organic EL element of the present invention, an electrode material having a low work function, such as aluminum, or an alloy having an even lower work function, such as a magnesium-silver alloy, a magnesium-indium alloy, or an aluminum-magnesium alloy, is used as the electrode material.

Hereinafter, embodiments of the present invention will be described in greater detail by way of examples. However, the present invention is not limited to the examples below.

### Examples

### Synthesis Example 1: Synthesis of Compound (1-1)

First, 8.3 g of bis(biphenylyl-4-yl)-amine, 8.4 g of 1-(4-bromophenyl)-3-phenylnaphthalene, 4.5 g of sodium t-butoxide, 0.4 g of t-butylphosphine (50 wt% solution in toluene), 0.2 g of palladium(II) acetate, and 84 ml of toluene were placed in a nitrogen-purged reaction vessel. Next, 7 g of silica gel was added to the reaction solution, which was then stirred for 10 minutes and subsequently subjected to Celite filtration at 80°C, and the solvent was distilled away under reduced pressure. The resulting mixture was subjected to separation using column chromatography to obtain 11.5 g of Compound (1-1) (yield: 82.0%).

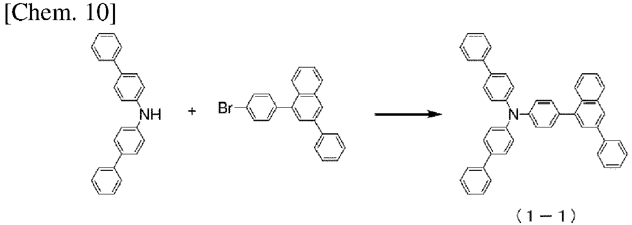

The structure of the obtained compound was identified using NMR.

In ¹H-NMR (CDCl₃), the following signals of 33 hydrogens were detected.
δ (ppm) = 8.11-8.08 (2H), 8.02-7.99 (1H), 7.83-7.80 (3H), 7.67-7.57 (9H), 7.55-7.42 (10H), 7.41-7.33 (8H).

### Synthesis Example 2: Synthesis of Compound (1-18)

First, 8.5 g of biphenyl-4-yl-{4'-(3-phenylnaphthalen-1-yl)-biphenyl-4-yl}-amine, 4.6 g of 9-bromophenanthrene, 2.3 g of sodium t-butoxide, 0.3 g of t-butylphosphine (50 wt% solution in toluene), 0.1 g of palladium(II) acetate, and 130 ml of toluene were placed in a nitrogen-purged reaction vessel. Next, 6 g of silica was added to the reaction solution, which was then stirred for 10 minutes and subsequently subjected to Celite filtration at 80°C, and the solvent was distilled away under reduced pressure. The resulting mixture was subjected to separation using column chromatography to obtain 4.7 g of Compound (1-18) (yield: 41.0%).

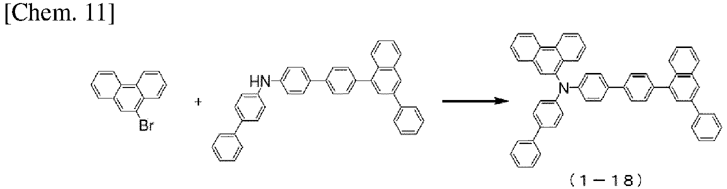

The structure of the obtained compound was identified using NMR.

In ¹H-NMR (CDCl₃), the following signals of 37 hydrogens were detected.
δ (ppm) = 8.78-8.72 (2H), 8.13-8.11 (1H), 8.06 (1H), 7.98-7.95 (2H), 7.80-7.65 (9H), 7.61-7.37(17H), 7.29-7.22 (5H).

### Synthesis Example 3: Synthesis of Compound (1-21)

First, 6.2 g of 4,4,5,5,-tetramethyl-2-{3-(3-phenylnaphthalen-1-yl)-phenyl}-[1,3,2]dioxaborolane, 6.6 g of bis(biphenyl-4-yl)-(4-bromophenyl)-amine, 1.8 g of sodium hydrogencarbonate, 0.2 g of 1,1'-bis(diphenylphosphino)ferrocenepalladium(II) dichloride, 80 ml of tetrahydrofuran, and 20 ml of water were placed in a nitrogen-purged reaction vessel and stirred for 8 hours while being heated under reflux. Then, the reaction solution was subjected to extraction with ethyl acetate. The organic layer was separated, and the solvent was distilled away under reduced pressure. Then, recrystallization was performed to obtain 5.7 g of Compound (1-21) (yield: 60.0%).

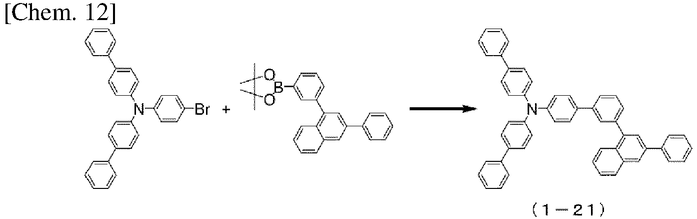

The structure of the obtained compound was identified using NMR.

In ¹H-NMR (CDCl₃), the following signals of 37 hydrogens were detected.
δ (ppm) = 8.08 (1H), 7.99-7.96 (2H), 7.78-7.76 (4H), 7.69-7.68 (1H), 7.60-7.36(22H), 7.33-7.29 (2H), 7.25-7.23 (5H).

### Synthesis Example 4: Synthesis of Compound (1-30)

First, 9.0 g (4-[1,1']binaphthalenyl-3-yl-phenyl)-biphenyl-4-yl-amine, 4.6 g of 4-bromobiphenyl, 2.6 g of sodium t-butoxide, 0.4 g of t-butylphosphine (50 wt% solution in toluene), 0.1 g of palladium(II) acetate, and 90 ml of toluene were placed in a nitrogen-purged reaction vessel and stirred for 3 hours while being heated under reflux. Then, 6.0 g of silica gel was added to the reaction solution, which was then stirred for 10 minutes and subsequently subjected to Celite filtration at 80°C, and the solvent was distilled away under reduced pressure. The resulting mixture was subjected to separation using column chromatography to obtain 5.8 g of Compound (1-30) (yield: 49.2%).

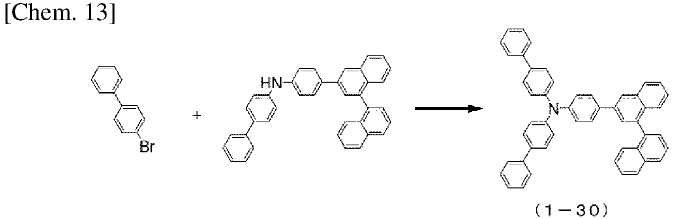

The structure of the obtained white powder was identified using NMR.

In ¹H-NMR (CDCl₃), the following signals of 35 hydrogens were detected.
δ (ppm) = 8.15 (1H), 7.99-7.94 (3H), 7.80-7.79 (1H), 7.71-7.69 (2H), 7.62-7.38(18H), 7.33-7.29 (10H).

### Synthesis Example 5: Synthesis of Compound (1-35)

First, 12.7 g of bis(biphenyl-4-yl)-{4'-(4,4,5,5-tetramethyl-[1,3,2]-dioxaborolan-2-yl)-biphenyl-4-yl}-am ine, 6.0 g of 3-bromo-1-phenylnaphthalene, 2.7 g of sodium hydrogencarbonate, 0.3 g of 1,1'-bis(diphenylphosphino)ferrocenepalladium(II) dichloride, 80 ml of tetrahydrofuran, and 25 ml of water were placed in a nitrogen-purged reaction vessel and stirred for 8 hours while being heated under reflux. Upon completion of the reaction, methanol was added to the reaction solution, and the resultant was then stirred for 1 hour and subsequently subjected to hot filtration. Then, recrystallization was performed to obtain 8.7 g of Compound (1-35) (yield: 60.6%).

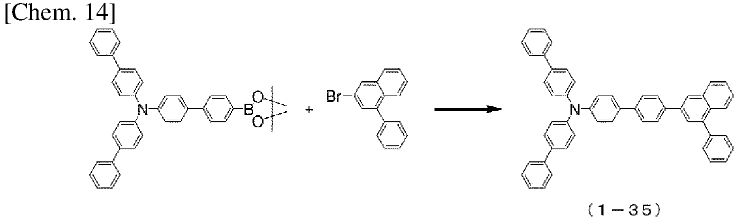

The structure of the obtained white powder was identified using NMR.

In ¹H-NMR (CDCl₃), the following signals of 37 hydrogens were detected.
δ (ppm) = 8.12 (1H), 7.99-7.97 (1H), 7.92-7.90 (1H), 7.85-7.83 (2H), 7.77-7.76 (1H), 7.73-7.71 (2H), 7.61-7.50 (15H), 7.48-7.41 (6H), 7.34-7.30 (2H), 7.27-7.24 (6H).

### Synthesis Example 6: Synthesis of Compound (1-52)

First, 5.8 g of 3-(4-chlorophenyl)-[1,2']-binaphthalenyl, 8.6 g of N,4',6',-triphenyl-[1,1':2',1"]terphenyl-4-amine, 3.2 g of sodium t-butoxide, 0.2 g of bis[tri(t-butylphosphine)]palladium(0), and 90 ml of toluene were placed in a nitrogen-purged reaction vessel and stirred for 12 hours while being heated under reflux. Then, 6.0 g of silica gel was added to the reaction solution, which was then stirred for 10 minutes and subsequently subjected to Celite filtration at 80°C. Then, the solvent was distilled away under reduced pressure. Then, hot filtration and recrystallization were performed to obtain 10.5 g of Compound (1-52) (yield: 79.8%).

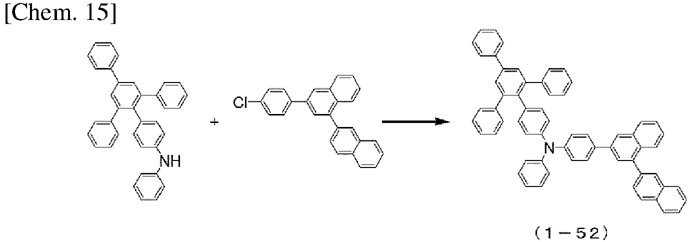

The structure of the obtained white powder was identified using NMR.

In ¹H-NMR (CDCl₃), the following signals of 43 hydrogens were detected.
δ (ppm) = 8.05 (1H), 8.01 (1H), 7.99-7.91 (5H), 7.78-7.77 (1H), 7.72-7.68 (5H), 7.62-7.60 (2H), 7.56-7.37 (7H), 7.26-7.19 (12H), 7.05-6.98 (5H), 6.81-6.75 (4H).

### Synthesis Example 7: Synthesis of Compound (1-16)

First, 9.1 g of biphenyl-4-yl-{4'-(3-phenylnaphthalen-1-yl)-biphenyl-4-yl}-amine, 7.6 g of 2-bromo-9,9-diphenyl-9H-fluorene, 2.5 g of sodium t-butoxide, 0.3 g of t-butylphosphine (50 wt% solution in toluene), 0.1 g of palladium(II) acetate, and 170 ml of toluene were placed in a nitrogen-purged reaction vessel and stirred for 3 hours while being heated under reflux. Then, 7.0 g of silica gel was added to the reaction solution, which was then stirred for 10 minutes and subsequently subjected to Celite filtration at 80°C. Then, the solvent was distilled away under reduced pressure, and subsequently, the resulting mixture was subjected to separation using column chromatography to obtain 9.2 g of Compound (1-16) (yield: 66.0%).

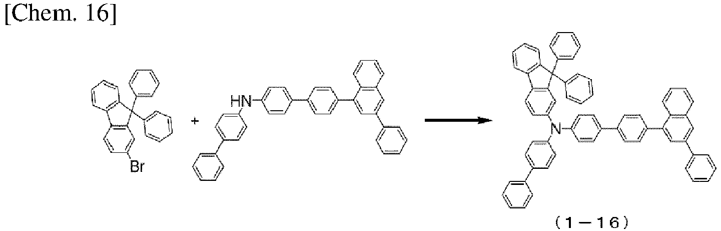

The structure of the obtained white powder was identified using NMR.

In ¹H-NMR (CDCl₃), the following signals of 45 hydrogens were detected.
δ (ppm) = 8.08 (1H), 8.01-7.97 (2H), 7.79-7.77 (3H), 7.73-7.69 (3H), 7.66-7.32(21H), 7.23-7.18 (15H).

### Synthesis Example 8: Synthesis of Compound (1-56)

First, 5.8 g of 3-(4-chlorophenyl)-[1,1']-binaphthalenyl, 11.5 g of (4-naphthalen-2-yl-phenyl)-phenyl-{4-(4,4,5,5-tetramethyl-[1,3,2]dioxaborolan-2-yl)-phe nyl}-amine, 70 ml of 1,4-dioxane, 21 ml of water, 0.5 g of tris(dibenzyliacetone)dipalladium(0), 0.5 g of tricyclohexylphosphine, and 8.1 g of tripotassium phosphate were placed in a nitrogen-purged reaction vessel and stirred for 12 hours while being heated under reflux. After completion of the reaction, extraction with ethyl acetate was performed. The organic layer was separated, and the solvent was distilled away under reduced pressure. Then, hot filtration and recrystallization were performed to obtain 10.1 g of Compound (1-56) (yield: 75.1%).

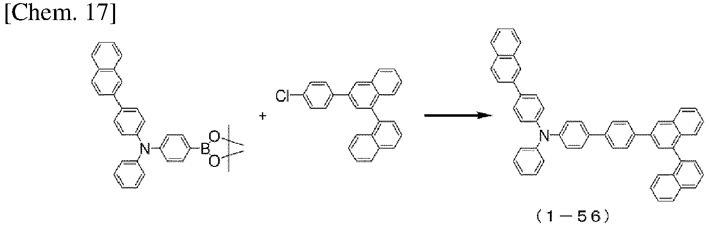

The structure of the obtained white powder was identified using NMR.

In ¹H-NMR (CDCl₃), the following signals of 37 hydrogens were detected.
δ (ppm) = 8.21 (1H), 7.95-8.02 (4H), 7.84-7.91 (6H), 7.75-7.76 (1H), 7.69-7.71 (2H), 7.62-7.65 (3H), 7.55-7.60 (3H), 7.45-7.52 (5H), 7.40-7.43 (1H), 7.27-7.33 (4H), 7.20-7.25 (6H), 7.06-7.10 (1H).

### Synthesis Example 9: Synthesis of Compound (1-6)

First, 8.5 g of (4-naphthalen-2-yl-phenyl)-{4-(3-phenyl-naphthalen-1-yl)phenyl}-amine, 5.3 g of 2-(4-bromobiphenyl)naphthalene, 2.5 g of sodium t-butoxide, 0.6 g of t-butylphosphine (50 wt% solution in toluene), 0.1 g of palladium(II) acetate, and 140 ml of toluene were placed in a nitrogen-purged reaction vessel and stirred for 5 hours while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to purification through crystallization from a dichloromethane/acetone mixed solvent to obtain 7.5 g of Compound (1-6) (yield: 62.7%).

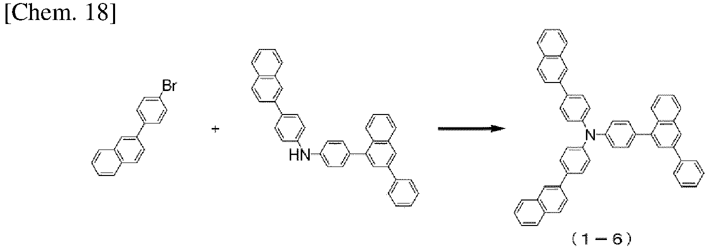

The structure of the obtained white powder was identified using NMR.

In ¹H-NMR (CDCl₃), the following signals of 37 hydrogens were detected.
δ (ppm) = 8.08 (1H), 8.06 (3H), 7.97 (1H), 7.91 (4H), 7.86 (2H), 7.78 (5H), 7.71 (4H), 7.57-7.43 (10H), 7.42-7.32 (7H).

### Synthesis Example 10: Synthesis of Compound (1-50)

First, 11.0 g of 4-(N-biphenyl-4-yl)-N-phenyl-amino-phenylboronic acid, 10.0 g of 3-(3-chlorophenyl)-[1,2']binaphthalenyl, 11.6 g of tripotassium phosphate, 0.8 g of tris(dibenzyliacetone)dipalladium(0), 0.8 g of tricyclohexylphosphine, 100 ml of 1,4-dioxane, and 30 ml of H₂O were placed in a nitrogen-purged reaction vessel and stirred overnight while being heated under reflux. Then, ethyl acetate was added to the reaction solution to perform extraction, and the organic layer was distilled away under reduced pressure. The resulting mixture was subjected to purification through crystallization from a dichloromethane/acetone mixed solvent to obtain 14.0 g of Compound (1-50) (yield: 78.6%).

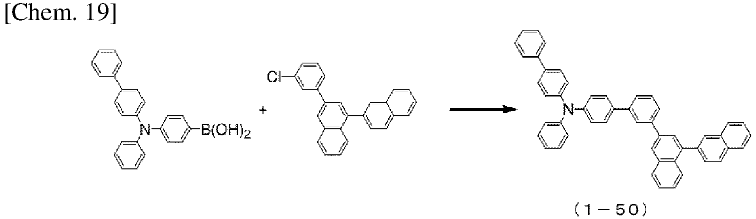

The structure of the obtained white powder was identified using NMR.

In ¹H-NMR (CDCl₃), the following signals of 35 hydrogens were detected.
δ (ppm) = 8.16 (1H), 8.03 (1H), 8.02-7.89 (6H), 7.87 (1H), 7.74 (1H), 7.70 (1H), 7.63-7.53 (9H), 7.50 (2H), 7.43 (3H), 7.30 (3H), 7.23 (6H), 7.06 (1H).

### Synthesis Example 11: Synthesis of Compound (1-77)

First, 7.0 g of (4-[1,2']binaphthalenyl-3-yl-phenyl)-phenyl-amine, 7.3 g of 2-bromo-9,9-diphenyl-fluorene, 2.4 g of sodium t-butoxide, 0.4 g of t-butylphosphine (50 wt% solution in toluene), 0.1 g of palladium(II) acetate, and 70 ml of toluene were placed in a nitrogen-purged reaction vessel and stirred for 3 hours while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to purification through crystallization from a monochlorobenzene/acetone mixed solvent to obtain 8.5 g of Compound (1-77) (yield: 69.2%).

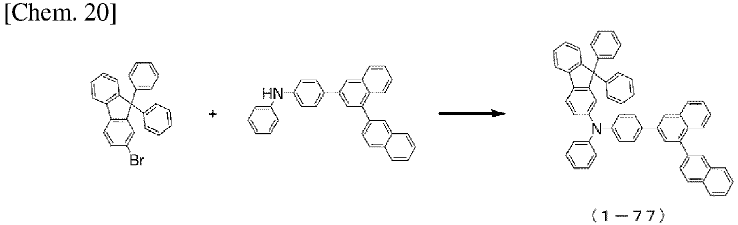

The structure of the obtained white powder was identified using NMR.

In ¹H-NMR (CDCl₃), the following signals of 39 hydrogens were detected.
δ (ppm) = 8.04 (2H), 7.97 (2H), 7.83 (3H), 7.78 (1H), 7.69 (2H), 7.60 (3H), 7.54 (3H), 7.41 (1H), 7.34 (2H), 7.29-7.10(18H), 7.08 (1H), 7.01 (1H).

### Synthesis Example 12: Synthesis of Compound (1-78)

First, 9.0 g of phenyl-{4-(6-phenyl-dibenzofuran-4-yl)phenyl}-amine, 8.8 g of 3-(4-chlorophenyl)-[1,1']-binaphthalenyl, 4.2 g of sodium t-butoxide, 0.2 g of bis[tri(t-butylphosphine)]palladium(0), and 90 ml of toluene were placed in a nitrogen-purged reaction vessel and stirred overnight while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to purification through crystallization from a dichloromethane/n-heptane mixed solvent to obtain 9.7 g of Compound (1-78) (yield: 59.8%).

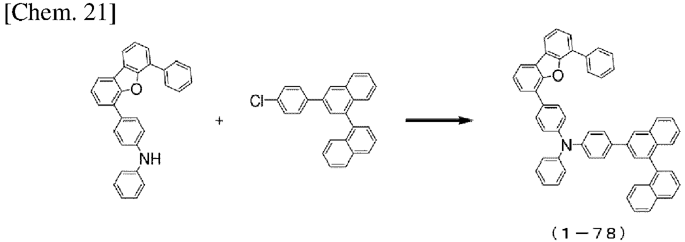

The structure of the obtained white powder was identified using NMR.

In ¹H-NMR (CDCl₃), the following signals of 37 hydrogens were detected.
δ (ppm) = 8.16 (1H), 8.02-7.91 (7H), 7.88 (2H), 7.81 (1H), 7.70 (2H), 7.67 (1H), 7.65 (1H), 7.61 (1H), 7.56 (1H), 7.52-7.42 (7H), 7.40 (1H), 7.37-7.22 (11H), 7.09 (1H).

### Synthesis Example 13: Synthesis of Compound (1-81)

First, 10.0 g of bis(biphenyl-4-yl)-{4-(4,4,5,5-tetramethyl-[1,3,2]dioxaborolan-2-yl)phenyl}-amine, 8.2 g of 3-biphenyl-3-yl-1-(4-chlorophenyl)-naphthalene, 8.1 g of tripotassium phosphate, 0.5 g of tris(dibenzyliacetone)dipalladium(0), 0.5 g of tricyclohexylphosphine, 100 ml of 1,4-dioxane, and 30 ml of H₂O were placed in a nitrogen-purged reaction vessel and stirred overnight while being heated under reflux. Then, ethyl acetate was added to the reaction solution to perform extraction, and the organic layer was distilled away under reduced pressure. The resulting mixture was subjected to purification through crystallization from a toluene/acetone mixed solvent to obtain 7.1 g of Compound (1-81) (yield: 49.6%).

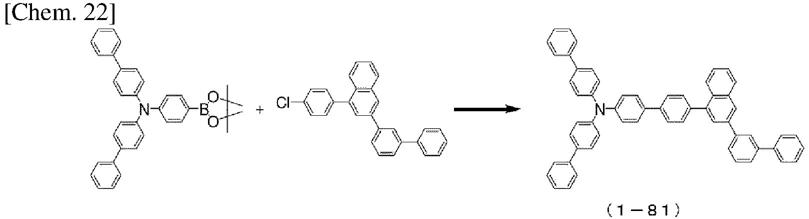

The structure of the obtained white powder was identified using NMR.

In ¹H-NMR (CDCl₃), the following signals of 41 hydrogens were detected.
δ (ppm) = 8.14 (1H), 8.00 (2H), 7.98 (1H), 7.82 (1H), 7.76 (3H), 7.69 (2H), 7.66-7.58 (10H), 7.58-7.52 (5H), 7.48 (3H), 7.44 (4H), 7.38 (1H), 7.33 (2H), 7.28 (6H).

### Synthesis Example 14: Synthesis of Compound (1-82)

First, 8.0 g of (4-naphthalen-2-yl-phenyl)-phenyl-{4-(4,4,5,5-tetramethyl-[1,3,2]dioxaborolan-2-yl)phen yl}-amine, 12.0 g of 4-(3-chlorophenyl)-[2,2']binaphthalenyl, 9.3 g of tripotassium phosphate, 0.6 g of tris(dibenzyliacetone)dipalladium(0), 0.6 g of tricyclohexylphosphine, 80 ml of 1,4-dioxane, and 24 ml of H₂O were placed in a nitrogen-purged reaction vessel and stirred overnight while being heated under reflux. After cooling the system, methanol was added thereto, and the deposited solid was taken out through filtration. The resulting mixture was subjected to purification through crystallization from a toluene/acetone mixed solvent to obtain 4.7 g of Compound (1-82) (yield: 30.7%).

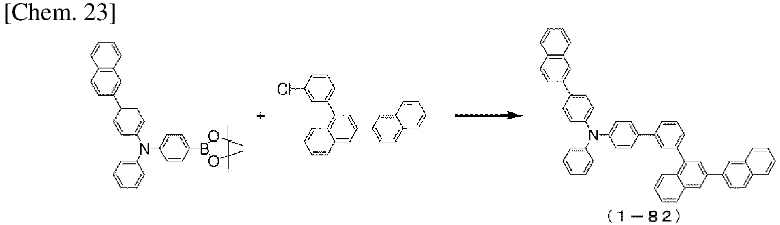

The structure of the obtained white powder was identified using NMR.

In ¹H-NMR (CDCl₃), the following signals of 37 hydrogens were detected.
δ (ppm) = 8.22 (2H), 8.01 (3H), 7.95 (2H), 7.91 (2H), 7.88 (4H), 7.82 (1H), 7.74 (1H), 7.70 (1H), 7.64 (1H), 7.61 (2H), 7.59 (2H), 7.55 (1H), 7.54-7.43 (6H), 7.31 (2H), 7.25-7.18 (6H), 7.07 (1H).

### Synthesis Example 15: Synthesis of Compound (1-84)

First, 6.4 g of bis(biphenyl-4-yl)-amine, 5.6 g of 4-{3-(4-chlorophenyl)naphthalen-1-yl}dibenzofuran, 2.3 g of sodium t-butoxide, 0.2 g of bis[tri(t-butylphosphine)]palladium(0), and 65 ml of toluene were placed in a nitrogen-purged reaction vessel and stirred overnight while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to purification through crystallization from a dichloromethane/acetone mixed solvent to obtain 9.7 g of Compound (1-84) (yield: 88.9%).

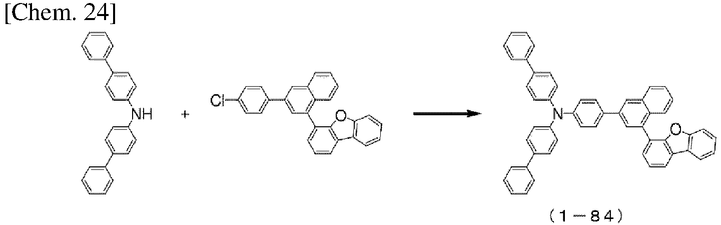

The structure of the obtained white powder was identified using NMR.

In ¹H-NMR (CDCl₃), the following signals of 35 hydrogens were detected.
δ (ppm) = 8.16 (1H), 8.07 (1H), 8.04 (1H), 8.01 (1H), 7.92 (1H), 7.72 (2H), 7.69 (1H), 7.60 (5H), 7.56-7.48 (6H), 7.47-7.40 (6H), 7.37 (3H), 7.31 (3H), 7.28 (2H), 7.25 (2H).

### Synthesis Example 16: Synthesis of Compound (1-88)

First, 5.7 g of phenyl-[1,1':4',1"]terphenyl-4-yl-amine, 6.5 g of 2-{3-(4-chlorophenyl)-naphthalen-1-yl}-dibenzofuran, 2.3 g of sodium t-butoxide, 0.2 g of bis[tri(t-butylphosphine)]palladium(0), and 65 ml of toluene were placed in a nitrogen-purged reaction vessel and stirred for 5 hours while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to purification through crystallization from a dichloromethane/acetone mixed solvent to obtain 2.2 g of Compound (1-88) (yield: 19.8%).

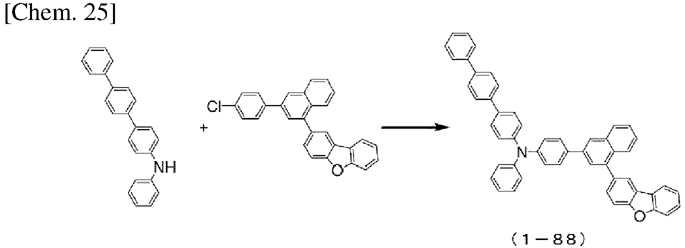

The structure of the obtained white powder was identified using NMR.

In ¹H-NMR (CDCl₃), the following signals of 35 hydrogens were detected.
δ (ppm) = 8.12 (1H), 8.09 (1H), 7.99 (1H), 7.97 (1H), 7.92 (1H), 7.80 (1H), 7.70 (3H), 7.67 (4H), 7.64 (4H), 7.56 (2H), 7.52 (1H), 7.49 (1H), 7.44 (3H), 7.42-7.28 (5H), 7.23 (5H), 7.08 (1H).

### Synthesis Example 17: Synthesis of Compound (1-95)

First, 9.5 g of biphenyl-4-yl-{4-(3-phenyl-naphthalen-1-yl)-phenyl}-amine, 9.0 g of 9-(4'-chlorobiphenyl-2-yl)-carbazole, 3.1 g of sodium t-butoxide, 0.2 g of bis[tri(t-butylphosphine)]palladium(0), and 95 ml of toluene were placed in a nitrogen-purged reaction vessel and stirred overnight while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to separation using column chromatography to obtain 6.6 g of Compound (1-95) (yield: 40.6%).

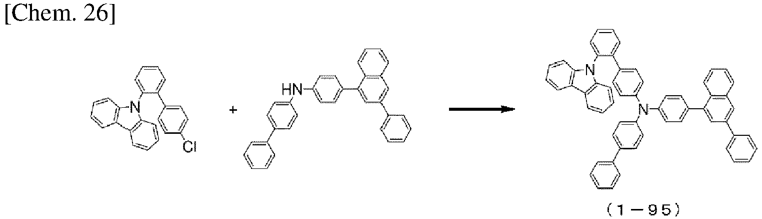

The structure of the obtained white powder was identified using NMR.

In ¹H-NMR (CDCl₃), the following signals of 40 hydrogens were detected.
δ (ppm) = 8.07 (2H), 8.05 (1H), 7.97 (2H), 7.77 (2H), 7.73 (1H), 7.71 (1H), 7.62-7.54 (5H), 7.50 (4H), 7.42 (5H), 7.34 (2H), 7.31 (3H), 7.23 (2H), 7.10 (2H), 6.92 (4H), 6.82 (4H).

### Synthesis Example 18: Synthesis of Compound (1-96)

First, 10.0 g of phenyl-{4-(1-phenyl-naphthalen-3-yl)-phenyl}-amine, 10.5 g of 9-(4'-chlorobiphenyl-2-yl)-carbazole, 3.9 g of sodium t-butoxide, 0.4 g of t-butylphosphine (50 wt% solution in toluene), 0.2 g of tris(dibenzyliacetone)dipalladium(0), and 100 ml of xylene were placed in a nitrogen-purged reaction vessel and stirred for 3 hours while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to separation using column chromatography to obtain 14.0 g of Compound (1-96) (yield: 75.5%).

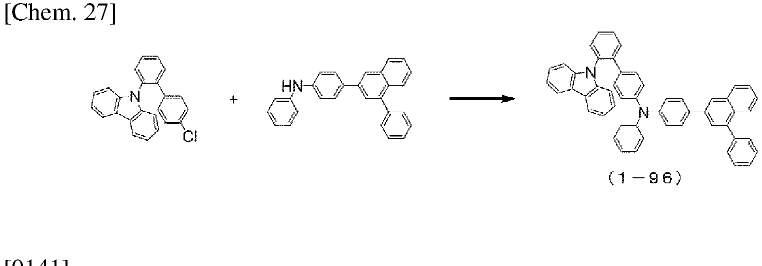

The structure of the obtained white powder was identified using NMR.

In ¹H-NMR (CDCl₃), the following signals of 36 hydrogens were detected.
δ (ppm) = 8.06 (2H), 7.99 (1H), 7.94 (1H), 7.89 (1H), 7.71 (1H), 7.66 (1H), 7.63-7.48 (10H), 7.46 (1H), 7.40 (1H), 7.30 (2H), 7.23 (2H), 7.16 (2H), 7.08 (2H), 6.96 (1H), 6.85 (2H), 6.80 (4H), 6.68 (2H).

### Synthesis Example 19: Synthesis of Compound (1-97)

First, 9.5 g of biphenyl-4-yl-{4-(1-phenyl-naphthalen-3-yl)-phenyl}-amine, 9.0 g of 9-(4'-chlorobiphenyl-2-yl)-carbazole, 3.1 g of sodium t-butoxide, 0.2 g of bis[tri(t-butylphosphine)]palladium(0), and 95 ml of toluene were placed in a nitrogen-purged reaction vessel and stirred overnight while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to separation using column chromatography to obtain 6.4 g of Compound (1-97) (yield: 39.5%).

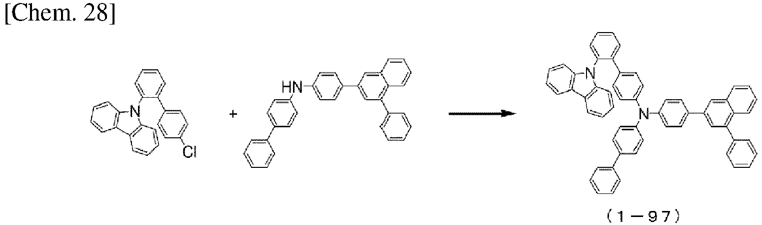

The structure of the obtained white powder was identified using NMR.

In ¹H-NMR (CDCl₃), the following signals of 40 hydrogens were detected.
δ (ppm) = 8.08 (2H), 8.01 (1H), 7.95 (1H), 7.89 (1H), 7.72 (1H), 7.67 (1H), 7.61 (1H), 7.60-7.49 (12H), 7.49-7.37 (6H), 7.31 (3H), 7.24 (1H), 7.09 (2H), 6.90 (2H), 6.86 (2H), 6.83 (2H), 6.74 (2H).

### Synthesis Example 20: Synthesis of Compound (1-98)

First, 7.0 g of phenyl-{4-(1-phenyl-naphthalen-3-yl)-phenyl}-amine, 8.0 g of 9-(4'-chlorobiphenyl-3-yl)-carbazole, 3.6 g of sodium t-butoxide, 0.2 g of bis[tri(t-butylphosphine)]palladium(0), and 150 ml of toluene were placed in a nitrogen-purged reaction vessel and stirred overnight while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to purification through crystallization from a dichloromethane/acetone mixed solvent to obtain 10.0 g of Compound (1-98) (yield: 77.0%).

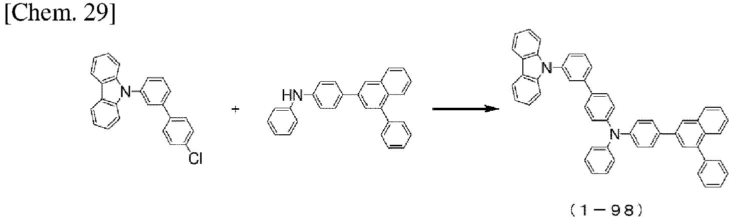

The structure of the obtained white powder was identified using NMR.

In ¹H-NMR (CDCl₃), the following signals of 36 hydrogens were detected.
δ (ppm) = 8.15 (2H), 8.03 (1H), 7.93 (1H), 7.89 (1H), 7.79 (1H), 7.69 (1H), 7.65 (4H), 7.57-7.45 (10H), 7.45-7.37 (4H), 7.29 (4H), 7.25-7.17 (6H), 7.07 (1H).

### Synthesis Example 21: Synthesis of Compound (1-99)

First, 9.0 g of biphenyl-4-yl-{4-(1-phenyl-naphthalen-3-yl)-phenyl}-amine, 8.5 g of 9-(4'-chlorobiphenyl-3-yl)-carbazole, 2.9 g of sodium t-butoxide, 0.2 g of bis[tri(t-butylphosphine)]palladium(0), and 90 ml of toluene were placed in a nitrogen-purged reaction vessel and stirred overnight while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to separation using column chromatography to obtain 3.0 g of Compound (1-99) (yield: 19.4%).

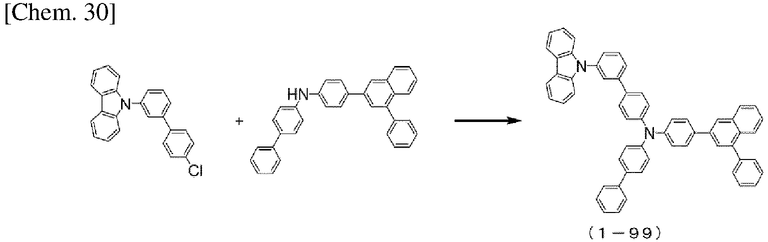

The structure of the obtained white powder was identified using NMR.

In ¹H-NMR (CDCl₃), the following signals of 40 hydrogens were detected.
δ (ppm) = 8.16 (2H), 8.05 (1H), 7.95 (1H), 7.90 (1H), 7.80 (1H), 7.69 (5H), 7.62-7.47 (15H), 7.47-7.38 (6H), 7.36-7.24 (8H).

### Synthesis Example 22: Synthesis of Compound (1-101)

First, 9.5 g of biphenyl-4-yl-(4'-carbazol-9-yl-biphenyl-4-yl)-amine, 7.4 g of 3-(4-chlorophenyl)-1-phenyl-naphthalene, 3.8 g of sodium t-butoxide, 0.2 g of bis[tri(t-butylphosphine)]palladium(0), and 170 ml of toluene were placed in a nitrogen-purged reaction vessel and stirred overnight while being heated under reflux. Then, silica gel was added to the reaction solution, which was then stirred for 30 minutes and subsequently subjected to Celite filtration at 90°C, and the solvent was distilled away under reduced pressure. The resulting mixture was subjected to purification through recrystallization from a toluene solvent to obtain 10.9 g of Compound (1-101) (yield: 73.0%).

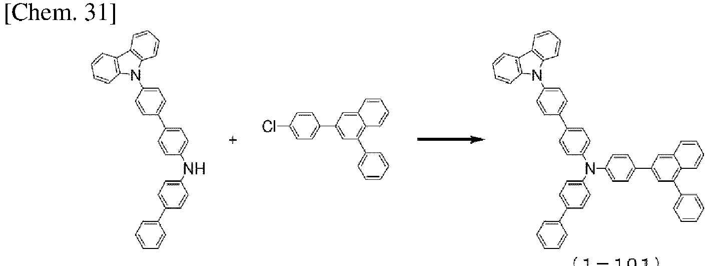

The structure of the obtained white powder was identified using NMR.

In ¹H-NMR (CDCl₃), the following signals of 40 hydrogens were detected.
δ (ppm) = 8.16 (2H), 8.07 (1H), 7.96 (1H), 7.91 (1H), 7.82 (2H), 7.73 (2H), 7.70 (1H), 7.62 (6H), 7.56 (4H), 7.54-7.39 (11H), 7.31 (9H).

### Synthesis Example 23

First, 20.0 g of Compound (2-11a) below, 18.4 g of Compound (2-11b) below, 0.5 g of palladium(II) acetate, 18.9 g of sodium t-butoxide, 0.8 g of tri(t-butyl)phosphine, and 200 mL of toluene were placed in a reaction vessel and stirred for 24 hours under reflux. After leaving the reaction solution to cool, the reaction solution was concentrated, and purified using column chromatography to obtain 21.5 g of a powder of Compound (2-11c) below (yield: 84%).

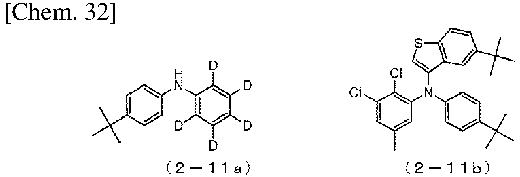

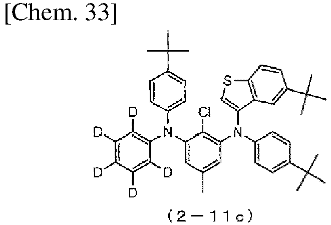

Next, 12.0 g of Compound (2-11c) above and 120 ml of tert-butylbenzene were placed in a reaction vessel, and 42.5 ml of n-butyllithium was added dropwise at -78°C. Then, nitrogen gas was passed therethrough under stirring at 60°C for 3 hours. Next, 11.3 g of boron tribromide was added dropwise at -78°C, followed by stirring at normal temperature for 1 hour, and then, 5.9 g of N,N-diisopropylethylamine was added dropwise at 0°C, followed by stirring at 120°C for 2 hours. After leaving the reaction solution to cool, an aqueous sodium acetate solution was added to the reaction solution. The resultant was then stirred and subjected to extraction with ethyl acetate, and the organic layer was concentrated. Then, the concentrated product was purified using column chromatography to obtain 1.7 g of a powder of Compound (2- 11) below (yield: 11%).

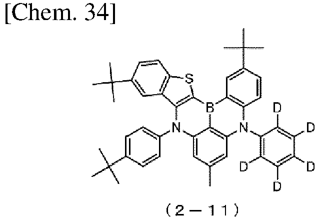

The glass transition point of each of the arylamine compounds obtained in Synthesis Examples 1 to 22 was measured using a high-sensitivity differential scanning calorimeter (DSC3100SA manufactured by Bruker AXS K.K.).

**Table 1**

| Glass transition point | |
|---|---|
| Compound (1-1) of Synthesis Example 1 | 117.0°C |
| Compound (1-18) of Synthesis Example 2 | 134.2°C |
| Compound (1-21) of Synthesis Example 3 | 108.0°C |
| Compound (1-30) of Synthesis Example 4 | 112.6°C |
| Compound (1-35) of Synthesis Example 5 | 115.3°C |
| Compound (1-52) of Synthesis Example 6 | 128.9°C |
| Compound (1-16) of Synthesis Example 7 | 144.3°C |
| Compound (1-56) of Synthesis Example 8 | 125.7°C |
| Compound (1-6) of Synthesis Example 9 | 111.4°C |
| Compound (1-50) of Synthesis Example 10 | 106.7°C |
| Compound (1-77) of Synthesis Example 11 | 133.2°C |
| Compound (1-78) of Synthesis Example 12 | 133.1°C |
| Compound (1-81) of Synthesis Example 13 | 116.9°C |
| Compound (1-82) of Synthesis Example 14 | 112.4°C |
| Compound (1-84) of Synthesis Example 15 | 126.8°C |
| Compound (1-88) of Synthesis Example 16 | 121.1°C |
| Compound (1-95) of Synthesis Example 17 | 125.0°C |
| Compound (1-96) of Synthesis Example 18 | 113.0°C |
| Compound (1-97) of Synthesis Example 19 | 124.0°C |
| Compound (1-98) of Synthesis Example 20 | 125.3°C |
| Compound (1-99) of Synthesis Example 21 | 129.1°C |
| Compound (1-101) of Synthesis Example 22 | 138.3°C |

The arylamine compounds obtained in Synthesis Examples 1 to 22 had a glass transition point of 100°C or higher, which indicates that these compounds are stable in the form of a thin film.

A vapor-deposited film (thickness: 100 nm) of each of the arylamine compounds obtained in Synthesis Examples 1 to 22 was formed on an ITO substrate, and the work function was measured using an ionization potential measuring system (PYS-202 manufactured by Sumitomo Heavy Industries, Ltd.).

**Table 2**

| Work function | |
|---|---|
| Compound (1-1) of Synthesis Example 1 | 5.66 eV |
| Compound (1-18) of Synthesis Example 2 | 5.69 eV |
| Compound (1-21) of Synthesis Example 3 | 5.66 eV |
| Compound (1-30) of Synthesis Example 4 | 5.66 eV |
| Compound (1-35) of Synthesis Example 5 | 5.65 eV |
| Compound (1-52) of Synthesis Example 6 | 5.69 eV |
| Compound (1-16) of Synthesis Example 7 | 5.59 eV |
| Compound (1-56) of Synthesis Example 8 | 5.68 eV |
| Compound (1-6) of Synthesis Example 9 | 5.67 eV |
| Compound (1-50) of Synthesis Example 10 | 5.67 eV |
| Compound (1-77) of Synthesis Example 11 | 5.60 eV |
| Compound (1-78) of Synthesis Example 12 | 5.69 eV |
| Compound (1-81) of Synthesis Example 13 | 5.64 eV |
| Compound (1-82) of Synthesis Example 14 | 5.66 eV |
| Compound (1-84) of Synthesis Example 15 | 5.74 eV |
| Compound (1-88) of Synthesis Example 16 | 5.77 eV |
| Compound (1-95) of Synthesis Example 17 | 5.67 eV |
| Compound (1-96) of Synthesis Example 18 | 5.64 eV |
| Compound (1-97) of Synthesis Example 19 | 5.62 eV |
| Compound (1-98) of Synthesis Example 20 | 5.67 eV |
| Compound (1-99) of Synthesis Example 21 | 5.68 eV |
| Compound (1-101) of Synthesis Example 22 | 5.68 eV |

It is shown that the arylamine compounds obtained in Synthesis Examples 1 to 22 had a more suitable energy level than common hole-transporting materials such as NPD and TPD, which have a work function of 5.4 eV, and that the arylamine compounds obtained thus had good hole-transporting capability.

### Example 1

An organic EL element was prepared by using the arylamine compound obtained in Synthesis Example 1, and the performance thereof was evaluated.

As shown in Fig. 15, the organic EL element was prepared in the following manner: a reflective ITO electrode serving as a transparent anode 2 was formed on a glass substrate 1 in advance, and a hole-injecting layer 3, a first hole-transporting layer 4, a second hole-transporting layer 5, a light-emitting layer 6, an electron-transporting layer 7, an electron-injecting layer 8, a cathode 9, and a capping layer 10 were vapor-deposited in this order on the ITO electrode.

Specifically, a glass substrate 1 on which an ITO film with a thickness of 50 nm, a reflective silver alloy film with a thickness of 100 nm, and an ITO film with a thickness of 5 nm were formed in this order as a transparent anode 2 was ultrasonically cleaned in isopropyl alcohol for 20 minutes, and then dried for 10 minutes on a hot plate heated to 250°C. After that, UV/ozone treatment was performed for 15 minutes. Then, the glass substrate with ITO was set inside a vacuum vapor deposition machine, and the pressure was reduced to 0.001 Pa or less.

Subsequently, an electron acceptor (Acceptor-1) having the structural formula below and a compound (HTM-1) having the structural formula below were vapor-deposited so as to coat the transparent anode 2 through binary vapor deposition at vapor deposition rates such that the ratio of the vapor deposition rate of Acceptor-1 to the vapor deposition rate of HTM-1 was 3:97, to thereby form a hole-injecting layer 3 with a thickness of 10 nm.

On this hole-injecting layer 3, the first hole-transporting layer 4 (thickness: 140 nm) made of HTM-1 having the structural formula below was formed.

On this first hole-transporting layer 4, the second hole-transporting layer 5 (thickness: 5 nm) made of Compound (1-1) of Synthesis Example 1 was formed.

On this second hole-transporting layer 5, Compound (2-11) of Example 23 and EMH-1 having the structural formula below were vapor-deposited through binary vapor deposition at vapor deposition rates such that the ratio of the vapor deposition rate of Compound (2-11) to the vapor deposition rate of EMH-1 was 5:95, to thereby form the light-emitting layer 6 with a thickness of 20 nm.

On this light-emitting layer 6, ETM-1 having the structural formula below and ETM-2 having the structural formula below were vapor-deposited through binary vapor deposition at vapor deposition rates such that the ratio of the vapor deposition rate of ETM-1 to the vapor deposition rate of ETM-2 was 50:50, to thereby form the electron-transporting layer 7 with a thickness of 30 nm.

On this electron-transporting layer 7, the electron-injecting layer 8 (thickness: 1 nm) made of lithium fluoride was formed.

On this electron-injecting layer 8, the cathode 9 (thickness: 12 nm) made of a magnesium-silver alloy was formed.

Finally, the capping layer 10 (thickness: 60 nm) made of CPL-1 having the structural formula below was formed.

Table 1 collectively shows the measurement results of the light emission characteristics when a DC voltage was applied to the prepared organic EL element in the atmosphere at normal temperature.

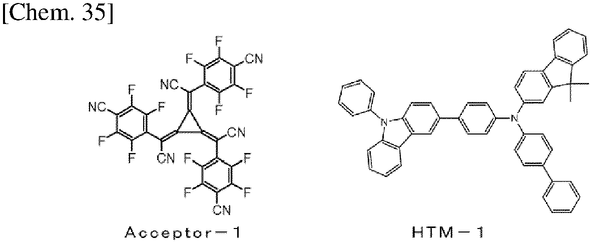

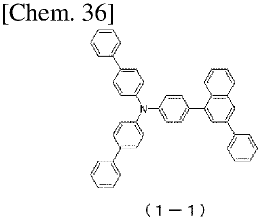

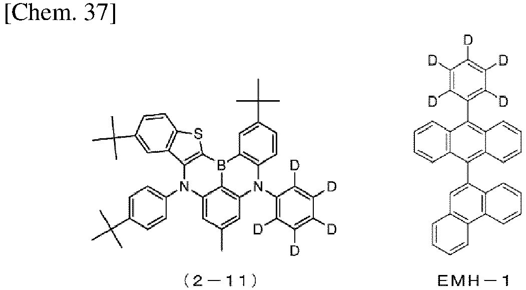

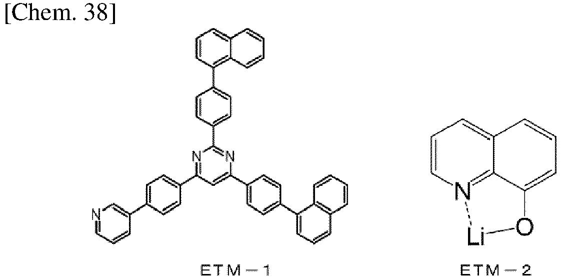

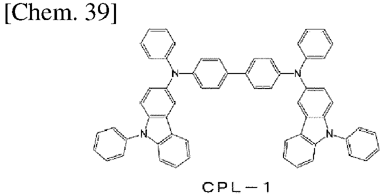

### Examples 2 to 22

Organic EL elements were prepared in the same manner as in Example 1, except that Compound (1-1) of Synthesis Example 1 used as the material for the second hole-transporting layer 5 was replaced with the compounds of Synthesis Examples 2 to 22, respectively. Table 1 collectively shows the measurement results of the light emission characteristics when a DC voltage was applied to the prepared organic EL element in the atmosphere at normal temperature.

### Comparative Example 1

For comparison, an organic EL element was prepared in the same manner as in Example 1, except that Compound (1-1) of Synthesis Example 1 used as the material for the second hole-transporting layer 5 was replaced with HTM-2 having the structural formula below. Table 1 collectively shows the measurement results of the light emission characteristics when a DC voltage was applied to the prepared organic EL element in the atmosphere at normal temperature.

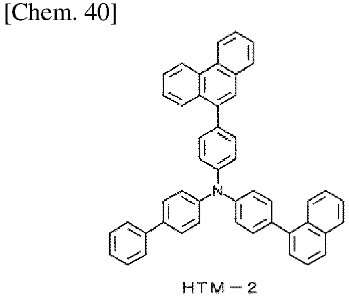

### Comparative Example 2

For comparison, an organic EL element was prepared in the same manner as in Example 1, except that Compound (1-1) of Synthesis Example 1 used as the material for the second hole-transporting layer 5 was replaced with HTM-3 having the structural formula below. Table 1 collectively shows the measurement results of the light emission characteristics when a DC voltage was applied to the prepared organic EL element in the atmosphere at normal temperature.

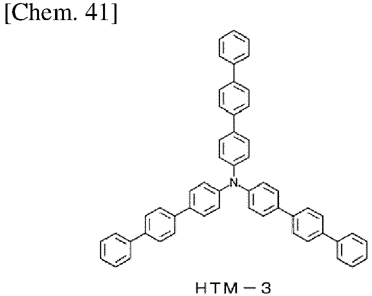

Table 1 collectively shows the measurement results of the element lifespan of each of the organic EL elements prepared in Examples 1 to 22 and Comparative Examples 1 and 2. The element lifespan was defined as follows: the organic EL element was driven by constant current to emit light at an initial luminance (the luminance when light emission started) of 2000 cd/m², and the time taken for the luminance to decay to 1900 cd/m² (corresponding to 95% based on the initial luminance (100%): 95% decay) was determined and used as the element lifespan.

**Table 3**

| | Second hole-transporting layer | Voltage [V] | Luminance [cd/m²] | Luminance efficiency [cd/A] | Power efficiency [lm/W] | Element lifespan [h] |
|---|---|---|---|---|---|---|
| Ex. 1 | Compound (1-1) | 3.26 | 1002 | 9.97 | 9.60 | 378 |
| Ex. 2 | Compound (1-18) | 3.32 | 995 | 9.93 | 9.37 | 393 |
| Ex. 3 | Compound (1-21) | 3.25 | 1008 | 10.03 | 9.41 | 471 |
| Ex. 4 | Compound (1-30) | 3.34 | 1029 | 10.27 | 9.53 | 504 |
| Ex. 5 | Compound (1-35) | 3.22 | 1010 | 10.09 | 9.84 | 381 |
| Ex. 6 | Compound (1-52) | 3.33 | 1009 | 10.06 | 9.49 | 476 |
| Ex. 7 | Compound (1-16) | 3.27 | 972 | 9.73 | 9.36 | 659 |
| Ex. 8 | Compound (1-56) | 3.30 | 1002 | 10.00 | 9.42 | 450 |
| Ex. 9 | Compound (1-6) | 3.33 | 960 | 9.62 | 9.28 | 373 |
| Ex. 10 | Compound (1-50) | 3.30 | 970 | 9.73 | 9.40 | 363 |
| Ex. 11 | Compound (1-77) | 3.24 | 970 | 9.51 | 9.19 | 420 |
| Ex. 12 | Compound (1-78) | 3.29 | 1009 | 10.11 | 10.04 | 622 |
| Ex. 13 | Compound (1-81) | 3.24 | 1040 | 10.40 | 10.08 | 423 |
| Ex. 14 | Compound (1-82) | 3.24 | 976 | 9.78 | 9.48 | 387 |
| Ex. 15 | Compound (1-84) | 3.21 | 989 | 9.89 | 9.60 | 417 |
| Ex. 16 | Compound (1-88) | 3.24 | 936 | 9.37 | 9.09 | 411 |
| Ex. 17 | Compound (1-95) | 3.23 | 1041 | 10.42 | 10.08 | 453 |
| Ex. 18 | Compound (1-96) | 3.27 | 1032 | 10.36 | 10.02 | 475 |
| Ex. 19 | Compound (1-97) | 3.27 | 1040 | 10.41 | 10.08 | 504 |
| Ex. 20 | Compound (1-98) | 3.31 | 989 | 9.89 | 9.62 | 433 |
| Ex. 21 | Compound (1-99) | 3.30 | 978 | 9.82 | 9.55 | 698 |
| Ex. 22 | Compound (1-101) | 3.25 | 962 | 9.84 | 9.41 | 423 |
| Com. Ex. 1 | HTM-2 | 3.45 | 840 | 8.41 | 7.67 | 322 |
| Com. Ex. 2 | HTM-3 | 3.55 | 825 | 8.25 | 7.61 | 246 |

The following can be seen from Table 1. When a current with a current density of 10 mA/cm² was applied, the organic EL elements of Comparative Examples 1 and 2 had a luminous efficiency of 8.25 to 8.41 cd/A, and on the other hand, the organic EL elements of Examples 1 to 22 had a luminous efficiency of 9.51 to 10.42 cd/A, which was higher efficiency. Moreover, while the organic EL elements of Comparative Examples 1 and 2 had a power efficiency of 7.61 to 7.67 lm/W, the organic EL elements of Examples 1 to 22 had a power efficiency of 9.28 to 10.08 lm/W and therefore exhibited higher efficiency. Furthermore, the organic EL elements of Comparative Examples 1 and 2 had an element lifespan (95% decay) of 246 to 322 hours, and in contrast, the organic EL elements of Examples 1 to 22 had an element lifespan as long as 363 to 698 hours.

As is clear from the above-described results, it was found that an arylamine compound having a specific structure represented by the general formula (1) above has larger hole mobility and superior electron-blocking capability compared with arylamine compounds known as conventional hole transport materials, and that the organic EL element of the present invention can thus achieve higher luminance efficiency and a longer lifespan compared with a conventional organic EL element.

### Industrial Applicability

An organic EL element including the arylamine compound having a specific structure of the present invention has increased luminance efficiency and improved durability, and therefore, can be applied to uses such as home electric appliances and lighting equipment.

### List of Reference Numerals

- 1: Glass substrate
- 2: Transparent anode
- 3: Hole-injecting layer
- 4: First hole-transporting layer
- 5: Second hole-transporting layer
- 6: Light-emitting layer
- 7: Electron-transporting layer
- 8: Electron-injecting layer
- 9: Cathode
- 10: Capping layer

## Claims

1. An organic electroluminescent element comprising a multilayer structure, wherein between an anode and a cathode, at least a first hole-transporting layer, a second hole-transporting layer, a blue light-emitting layer, and an electron-transporting layer are provided in this order from the anode side, and wherein a layer containing a triarylamine compound represented by the general formula (1) below is set between the first hole-transporting layer and the electron-transporting layer: 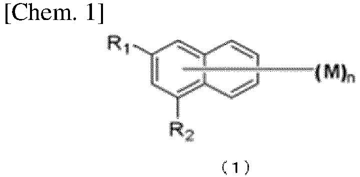
wherein, R₁ and R₂ may be the same or different and each represent a group of the general formula (2-1) or (2-2) below, and one of R₁ and R₂ represents a group of the general formula (2-1);
M represents a deuterium atom, a fluorine atom, a chlorine atom, a cyano group, a nitro group, a thiol group, a hydroxy group, a substituted or unsubstituted linear or branched alkyl group having 1 to 6 carbon atoms, a substituted or unsubstituted cycloalkyl group having 5 to 10 carbon atoms, a substituted or unsubstituted linear or branched alkenyl group having 2 to 6 carbon atoms, a substituted or unsubstituted linear or branched alkyloxy group having 1 to 6 carbon atoms, a cycloalkyloxy group having 5 to 10 carbon atoms and optionally having a substituent, a substituted or unsubstituted aryloxy group, a substituted or unsubstituted aromatic hydrocarbon group, a substituted or unsubstituted aromatic heterocyclic group, a substituted or unsubstituted silyl group, or a substituted or unsubstituted boron group; and
n is an integer of 0 to 4; if n is 2 or more, M may be the same or different, and adjacent M may be optionally linked to each other to form a ring via a single bond, a substituted or unsubstituted methylene group, an oxygen atom, a sulfur atom, or a monosubstituted nitrogen atom: 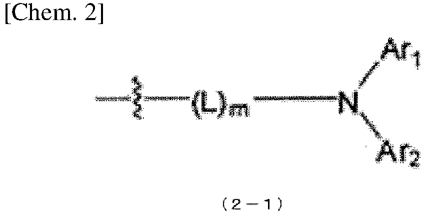 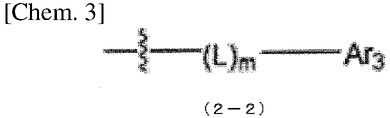
wherein, L is a linking group and represents a substituted or unsubstituted divalent aromatic hydrocarbon group or a substituted or unsubstituted divalent aromatic heterocyclic group;
m is an integer of 0 to 4; if m is 0, L represents a single bond, and if m is 2 or more, L may be the same or different;
Ar₁ and Ar₂ may be the same or different and each represent a substituted or unsubstituted aromatic hydrocarbon group or a substituted or unsubstituted aromatic heterocyclic group; and
Ar₃ represents a substituted or unsubstituted aromatic hydrocarbon group.

2. The organic electroluminescent element according to claim 1, wherein the layer containing the triarylamine compound represented by the general formula (1) is the second hole-transporting layer.

3. The organic electroluminescent element according to claim 1, wherein, in the general formula (1), R₁ represents a group of the general formula (2-1), and R₂ represents a group of the general formula (2-2).

4. The organic electroluminescent element according to claim 1, wherein, in the general formula (1), R₁ represents a group of the general formula (2-2), and R₂ represents a group of the general formula (2-1).

5. The organic electroluminescent element according to any one of claims 1 to 4, wherein the blue light-emitting layer contains a pyrene derivative having a pyrene skeleton in a molecule thereof.

6. The organic electroluminescent element according to any one of claims 1 to 4, wherein the blue light-emitting layer contains a compound represented by the general formula (3-1) or (3-2) below: 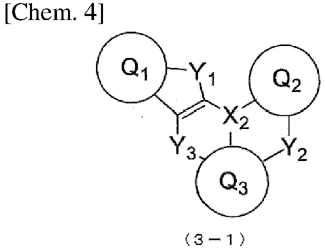 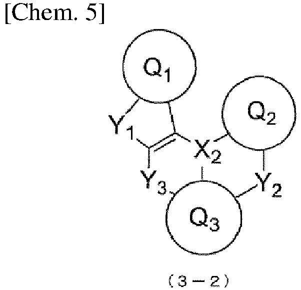
wherein, Q₁, Q₂, and Q₃ may be the same or different and each represent a substituted or unsubstituted aromatic hydrocarbon or a substituted or unsubstituted aromatic heterocycle;
X₂ represents B, P, P=O, or P=S; and
Y₁, Y₂, and Y₃ may be the same or different and each represent N-R₃, C-R₄R₅, O, S, Se, or Si-R₆R₇, where R₃, R₄, R₅, R₆, and R₇ may be the same or different and each represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, or a substituted or unsubstituted aryloxy group, and the groups R₄ and R₅, and the groups R₆ and R₇, may be optionally bonded to each other to form a ring via a single bond, a substituted or unsubstituted methylene group, an oxygen atom, a sulfur atom, or a monosubstituted amino group, and if Y₁, Y₂, and Y₃ each represents N-R₃, C-R₄R₅, or Si-R₆R₇, each of R₃, R₄, R₅, R₆, and R₇ may be optionally bonded to its adjacent Q₁, Q₂, or Q₃ to form a ring via a single bond, a substituted or unsubstituted methylene group, an oxygen atom, a sulfur atom, or a monosubstituted amino group.

7. The organic electroluminescent element according to any one of claims 1 to 4, wherein the blue light-emitting layer contains an anthracene derivative having an anthracene skeleton in a molecule thereof.
